# EUROPEAN PATENT SPECIFICATION

(11) **EP 2 723 913 B1**
(45) Date of publication and mention of the grant of the patent: **22.08.2018**
(21) Application number: 11730607.6
(22) Date of filing: 22.06.2011
(51) Int. Cl.: C23C 14/12, C23C 14/22, C23C 14/24, C23C 14/56, C23C 14/26

(54) **VAPOR DEPOSITION SYSTEM AND SUPPLY HEAD**
AUFDAMPFUNGSSYSTEM UND ZUFÜHRUNGSKOPF
SYSTÈME DE DÉPÔT EN PHASE VAPEUR ET TÊTE D'ALIMENTATION

(43) Date of publication of application: 30.04.2014
(73) Proprietor: Aixtron SE, 52134 Herzogenrath (DE)
(72) Inventor: LONG, Michael, 52134 Herzogenrath-Kohlscheid (DE); GERSDORFF, Markus, 52134 Herzogenrath (DE); GOPI, Baskar Pagadala, 52072 Aachen (DE)
(74) Representative: Grundmann, Dirk
(86) International application number: PCT/EP2011/060477
(87) International publication number: WO 2012/175128

(56) References cited:
- WO-A1-2009/020562
- US-A- 5 059 292
- US-A1- 2005 186 412
- US-A1- 2008 193 644

## Description

### CROSS REFERENCE TO RELATED APPLICATIONS

### FIELD OF THE INVENTION

The present invention relates generally to the field of physical vapor deposition and more specifically to Organic Vapor Phase Deposition where a source material is heated to a temperature so as to cause vaporization and a vapor plume is created that mixes with and is transported by an inert carrier gas to a substrate where the organic material condenses to form a thin film.

### BACKGROUND OF THE INVENTION

There are numerous methods for vapor depositing materials onto the surface of a substrate known in the prior art. Most often, at the start of a production run a crucible is filled with hundreds of grams of material to be deposited on the substrate. The material is placed in the crucible in powdered form. The crucible and its contents are then heated to a temperature that provides the desired vaporization rate.

This approach can achieve a very stable deposition rate using a crystal rate monitor to provide feedback to a slow response temperature control system but exposes much of the material in the crucible to high temperatures for an extended time period. This extended exposure to high temperatures poses a significant risk of thermal decomposition to many materials, particularly organic materials used in OLED (organic light-emitting diode) devices. These methods are additionally unable to rapidly initiate and interrupt vaporization. The chemical distinction between organic and inorganic materials is somewhat arbitrary but typically, in the thin film deposition field, one considers metals and their oxides, nitrides and carbides as being inorganic. By this definition, the risk of decomposition with inorganic materials is very low by comparison. Even the precursors used in metalorganic Chemical Vapor Deposition (MOCVD) (metalorganic chemical vapor deposition) are very thermally stable relative to the organic materials used for small molecule OLED devices. To address these problems, automatic refilling or crucible exchanging systems have been developed where a small quantity of organic material is introduced on a repeating basis such that it is consumed before significant decomposition occurs as shown in US Pub. No. 20090061090 by Negishi. In some static deposition systems such as taught in US Pub. No. 20100015324 by Negishi, the quantity of organic material introduced per cycle is described as corresponding precisely to the desired deposited film thickness and no attempt is made to control the deposition rate.

Flash vaporization sources have also been developed to address the decomposition issue by metering cooled, powdered organic material to a heated screen element as taught in US Patent no. 7,288,286 by Long or to a porous heating element as taught in US Pub. No. 2009 0039175 by Long and in US Patent no. 6,037,241 by Powell, on an as-needed basis. These sources reduce the thermal exposure time of the organic material to a second or two and allow rapid initiation and interruption of vaporization of single component and multi-component powder mixtures having widely different saturation vapor pressures. To achieve a stable deposition rate however, these systems require fast response feedback systems to compensate for variability in the material feed rate and variability in the vapor generation rate due to variations in powder particle size and packing density. A stable deposition rate, in terms of OLED material deposition, requires material feed accuracy measured in tens of micrograms and feed rate stability in single digit micrograms per second per square meter of substrate surface area.

US Pub. No. 20080193644 by Frob describes a porous heating element that is loadable such that the porous structure is packed with a powdered material to be coated onto a substrate. The powdered material is vaporized when the temperature of the heating element is raised.

The difficulty in precisely metering fine powders due to their tendency to adhere to surfaces and agglomerate, the vaporization variability due to particle size variation and the poor thermal conductivity of powders have motivated the development of solid and liquid fed systems. Transforming the powdered organic material into a solid pellet typically requires further grinding the powders to achieve sub micron particle sizes and sometimes the addition of inert binders before pressing the mixture in a hydraulic press to insure some minimum level of solid integrity. The displacement of the solid pellet is precisely controlled as it is advanced, usually to a grinding apparatus to recreate a powder stream or aerosol that is then directed to a heating element for vaporization as in US Patent no. 5,820,678 by Hubert. In this method, the majority of the variability of handling powders is moved to the pellet preparation process at some additional cost with the additional caveat that there is an increased likelihood of contamination to the organic material.

Vaporization apparatus based on spraying a stream of atomized liquid droplets have been developed for vaporizing liquid precursors in MOCVD systems. Apparatus of similar concept have been adapted for use with organic materials, such as taught in US Pub. No. 20050227004 by Burrows. US Pub. No. 20060115585 by Bulovic and US Patent no. 5,204,314 by Kirlin disclose processes involving jetted droplets. These systems benefit from the well developed technology for precisely dispensing even very small quantities of liquids and benefit from the ability of the liquid to rapidly conduct heat from the heating element and vaporize almost immediately.

Vapor depositing OLED materials can be even more problematic. An OLED device includes a substrate, an anode, a hole injecting and transporting layer made of an organic compound, one or more organic luminescent layers with suitable dopants, an organic electron injection and transporting layer, and a cathode. OLED devices are attractive because of their low driving voltage, high luminance, wide-angle viewing and capability for full color, thin emissive displays. Tang et al. described this multilayer OLED device in their U.S. Pat. Nos. 4,769,292 and 4,885,211. High performance OLED devices have been commercialized using manufacturing processes that rely on heating the organic materials to temperatures sufficient to cause sublimation. The organic material vapors are then condensed as thin films on the surface of a substrate to form an OLED device.

An important distinction between the MOCVD systems and the OLED systems is that the MOCVD precursors are liquids whereas the OLED materials are solids below 200°C and can typically only be dissolved to a 1 or 2 percent concentration in solvents. As a result, substantial volumes of solvent vapor are generated as the liquids are vaporized. Systems based on suspensions of the organic material particles in an inert liquid have higher material loading but maintaining suspension homogeneity is problematic. In all cases, it has proven extremely difficult to remove trace contaminants from the liquids that diminish the OLED device performance and to additionally insure that solvent molecules, potentially incorporated in the deposited films do not decrease device lifetime or efficiency.

The inherent difficulty in removing trace contaminants from liquids is a fundamental reason why OLED materials are subjected to a thermal evaporation purification process that is often repeated several times before the desired purity is achieved. The material resulting from the liquid based chemical synthesis of the desired organic molecule is purified through a thermal vaporization process by heating it in a crucible and directing the vapor to condense along the length of a condensate collection tube having a controlled temperature and temperature gradient. Contaminants having lower volatility than the target molecule tend to condense preferentially at the hotter end of the glass tube while higher volatility contaminants tent to condense preferentially at the colder end of the tube. In principle, with the right temperature and temperature gradient along the condensate collection tube, high purity condensed films can be recovered from a zone near the middle of the tube. The condensate film is removed, as flakes from the walls of the condensate collection tube and is ground into powder form. After one or more purification sublimation cycles, high purity condensate is recovered and is ultimately ground into the final powder form having a specified particle size range.

US Patent no. 5,059,292 to Collins et al. describes a single chamber apparatus and method for in-situ generation of dangerous polyatomic gases and radicals from solid or liquid source materials contained within a porous foamed structure that is used for both storage and evaporation. A cooled cathode is provided for establishing a plasma discharge within the chamber and a heat source is provided to maintain the porous foamed structure within a fixed temperature range chosen such that the source material is removed from the porous foamed structure by evaporation induced by heat from the heat source while at the same time preventing consumption by evaporation of the porous foamed structure itself. The source material is put into the liquid state (by melting from a solid if applicable) and is absorbed in large amounts into the pores of the foamed structure. The foamed structure acts as a large capacity reservoir for the source material and as heat is applied to vaporize the source material from a surface of the foamed structure, new source material continually wicks to the heated surface.

### SUMMARY OF THE INVENTION

The prior art fails to teach a vapor deposition method wherein the deposition rate stability on the target is decoupled from any variability in the replenishment vapor flux due to difficulties and variability in metering and vaporizing minute powder quantities on an as-needed basis. This is accomplished through the use of a conductive open cell structure as an intermediate vapor deposition receptacle. The conductive open cell structure of the intermediate vapor deposition receptacle is preferably electrically conductive, but may instead be thermally conductive, or it may be both electrically and thermally conductive. The material to be vapor deposited on the target substrate is first vapor deposited in the open cell structure of the intermediate vapor deposition receptacle such that the intermediate vapor deposition receptacle becomes a vapor deposition material source structure. The vapor deposition material source structure then may be used as a vapor deposition material source for vapor deposition on the final target substrate. With this arrangement, the vapor generation rate stability of the open cell structure of the vapor deposition material source structure determines the deposition rate stability on the target substrate. By utilizing a phase change from gas to solid between the input vapor and the output vapor in the open cell structure, the objective of establishing and maintaining a precise and substantially invariant flux of the output vapor is decoupled from the difficulties of maintaining a stable deposition rate from a vapor on demand flash vaporization system. The term "substantially invariant" is used herein to denote deposition rate stability better than +/- 0.5%. This stability is maintained when the foam is re-vaporizing condensate deposited at a much earlier time (temporal separation) as well as when vapor with a stability of +/- 8% is entering one side of the foam and condensing while vapor with a stability of +/- 0.5% or better is simultaneously exiting the other side of the foam (spatial separation).

The invention allows substantial simplification in the preparation and vaporization of vapor deposition materials, particularly of organic material for making OLED devices through consideration of the organic material purification process and consideration of the variables such as temperature, thermal exposure time, thermal conductivity, surface area, partial pressure, total pressure and convection that control organic material vaporization and decomposition.

According to one aspect of the present invention a vapor deposition system is provided for delivering a mixture of a carrier gas and a deposition gas to a temperature controlled target substrate comprising a first member; a second member positioned adjecent to the first member for relative movement between both of the members. The first member may have a plurality of support faces, each provided with a three-dimensional, open cell, reticulated structure which forms a heater element.. The first element can be a slider which is linear moveable relative to a slider carrier. It is prefered that the first member is a rotor and the second member is a stator positioned within the rotor for relative rotational movement between the stator and the rotor, the rotor including a plurality of support faces, each of the support faces having a frame mounted thereto; an electrically conductive, three-dimensional, open cell reticulated structure heater element having a solid coating of a selected vapor deposition material vapor deposited thereon supported within each frame, the heater element capable of controllably vaporizing the solid coating; a carrier gas feed tube connected to the stator for delivering carrier gas to a delivery duct within the stator; a plurality of facet ducts in the rotor, each facet duct aligning with a respective support face, the relative rotational movement of the rotor and stator allowing the delivery duct to be aligned with any selected one of the facet ducts, the carrier gas thereby flowing through the heater element adjacent the selected facet duct.

According to a second aspect of the present invention a rechargeable vapor deposition source supply head is provided for delivering a mixture of a carrier gas and a deposition gas to a temperature controlled target substrate comprising a rotor having a plurality of heater ducts therethrough and having a plurality of heater elements supported therefrom in substantial planar alignment with each other, each heater element aligning with a respective heater duct, each heater element being an electrically conductive, three-dimensional, open cell, reticulated structure having a solid coating of a selected vapor deposition material vapor deposited thereon, the heater element capable of controllably vaporizing the solid coating; a stator attached to the rotor such that the rotor rotates relative to the stator, the stator including a carrier gas feed duct and a deposition gas feed duct, the rotor being rotatable to align a selected heater element with either the carrier gas feed duct or the deposition gas feed duct; a carrier gas feed tube connected to the stator for delivering carrier gas to carrier gas feed duct; and a deposition gas feed tube connected to the stator for delivering deposition gas to the deposition gas feed duct.

According to a third aspect of the present invention a vapor deposition apparatus is provided comprising at least one vapor generator source for supplying a replenishment deposition gas to a plenum; at least one carrier gas supply line for supplying a carrier gas through the at least one vapor generator source to the plenum such that the replenishment deposition gas and the carrier gas form a first mixture that is delivered to the plenum; a conductive, three-dimensional, open cell, reticulated structure having a solid coating of a vapor deposition material thereon, the conductive, three-dimensional, open cell, reticulated structure residing within the plenum, the three-dimensional, open cell, reticulated structure having a temperature gradient therethrough in the direction of flow such that the replenishment deposition gas condenses on the conductive, three-dimensional, open cell, reticulated structure; means for vaporizing the solid coating to form a deposition gas that mixes with the carrier gas to form a second mixture; means for delivering the second mixture at a stable flow rate to a temperature controlled substrate within a chamber; and an exhaust port through which the carrier gas is withdrawn from the chamber.

According to a fourth aspect of the present invention a vapor deposition apparatus is provided comprising a plurality of vapor deposition heads positioned within a deposition chamber, each deposition head including a conductive, three-dimensional, open cell, reticulated structure having a solid coating of a vapor deposition material thereon; and a conveyor system residing within the deposition chamber for transporting at least one target substrate through the deposition chamber in close proximity to the plurality of deposition heads with each of the plurality of vapor deposition heads depositing a separate layer of vapor deposition material on the at least one target substrate. Each of the deposition heads may comprise a cartridge which is formed by a three-dimensional, open cell, reticulated structure which is arranged exchangeable inside a plenum. The cartridge forms an exchangeable source for vapor deposition material. The head can be charged by replacing a spent cartridge by a charged cartridge.

According to another aspect of the present invention the conductive three-dimensional, open cell, reticulated structure is preferably a vitreous carbon foam. A coating of a refractory metal or ceramic material vapor may first be vapor deposited on the conductive three-dimensional, open cell, reticulated structure, the solid coating of the selected vapor deposition material residing on top of the coating of the refractory metal or ceramic material. The solid coating of the selected vapor deposition material has a thickness in the range of from about 1nm to about 2µm and is substantially free of contaminants. The selected vapor deposition material is an organic or organo-metallic material such as an OLED material.

The three-dimensional open cell, reticulated structure is preferably composed of struts or ligaments. The ligaments collectively have a large surface area relative to the deposition target and the ligaments collect the organic material vapor in the form of a conformal, thin condensate coating. The open cell element includes means for generating heat in or conducting heat into the ligaments and a means for controlling the temperature of the ligaments so as to controllably vaporize the conformal organic material coating condensed thereon. The large surface area of contact and the low thermal contact resistance between the ligaments and the organic material condensed thereon provide a controllable and unusually large organic vapor flux for a given heating element volume and temperature.

An inert gas is caused to flow through the three-dimensional open cell element and around the ligaments, the ligaments providing a tortuous flow path that promotes mixing of the inert gas with the organic vapor generated around the heated ligaments. The flow and temperature of the gas contribute to controlling the rate of generation and transport of the organic vapor toward the deposition target.

The conductive three-dimensional, open cell, reticulated structure is preferably an open cell vitreous carbon foam. Open cell vitreous carbon foam, also called reticulated vitreous carbon foam, is a vitreous carbon structure of three dimensional interconnected polyhedron cells. Vitreous carbon is a glassy carbon as opposed to a graphitic carbon. A cell is typically comprised of 12 to 14 connected struts or ligaments which form a three dimensional polyhedron. An open cell is a cell where no film or solid is connected between the ligaments so that there is free communication in to and out of a cell, and in a group of adjoining cells all cells are interconnected and form a three dimensional interconnected structure. Open cell foam has a structure which typically consists of three dimensional interconnected polyhedron cells with 12 to 14 ligaments composing each cell, and each cell having a spheroidal shape. A method for producing reticulated carbon foam is taught in US Patent no. 6,103,149 to Stankiewicz. Stankiewicz states that the vitreous carbon foam is often coated with other materials via a chemical vapor deposition process. If the underlying vitreous carbon foam has a vast majority of cells with aspect ratios greatly different than 1 the resultant coated foam will have cells with aspect ratios greatly different than 1 and the resultant coated foam may have anisotropic properties. Chemical vapor deposition is used to coat carbon foams with ceramics such as SiC or BN and metals such as W or Ta.

### BRIEF DESCRIPTION OF THE DRAWINGS

Figure 1 depicts a schematic view of an open cell intermediate vapor deposition receptacle within a condensate collection tube of a sublimation purification apparatus, all of which is contained within a deposition chamber.
Figure 1A is a graph illustrating the temperature gradient across the condensate collection tube.
Figure 2 is a magnified view of the open cell intermediate deposition receptacle where the interconnected ligaments composing the foam are clearly visible.
Figure 3 is a highly magnified cross section of a ligament composing the open cell vapor deposition receptacle with a coating of a refractory metal or ceramic and/ or vaporizable material thereon.
Figure 4 is a schematic depiction of a vapor deposition apparatus using the open cell vapor deposition material source structure for vapor deposition
Figure 4A depicts a cross sectional view of an open cell vapor deposition material source structure and accompanying support structure taken along line III - III of Figure 4.
Figure 5 depicts a schematic view of an alternative vapor deposition apparatus to the apparatus of Figure 4 including two open cell vapor deposition material source structures for vapor deposition.
Figure 6 depicts a cross sectional view of an open cell vapor deposition material source structure and accompanying support structure taken along line IV - IV of Figure 5.
Figure 6A depicts a cross sectional view of an open cell vapor deposition material source structure and accompanying support structure taken along line V - V of Figure 5.
Figure 7 depicts a top view of an exemplary apparatus wherein multiple condensate coated foam heating elements can be loaded on a deposition head and sequentially heated to generate a material vapor and wherein a controllable carrier gas flow is directed through the active open cell deposition receptacle to acquire the material vapor in the carrier gas and deposit a material film on a facing substrate surface.
Figure 8 depicts a perspective view of the exemplary apparatus of Figure 7. Figure 9 is a top view of an exemplary apparatus wherein multiple condensate coated foam heating elements are loaded on more than one deposition head (as depicted in Figure 8) and are sequentially heated to generate multiple material vapors and wherein carrier gas flows are directed through respective active open cell deposition receptacles to acquire the material vapors in the carrier gas and deposit multiple material film on respective facing substrate surfaces simultaneously.

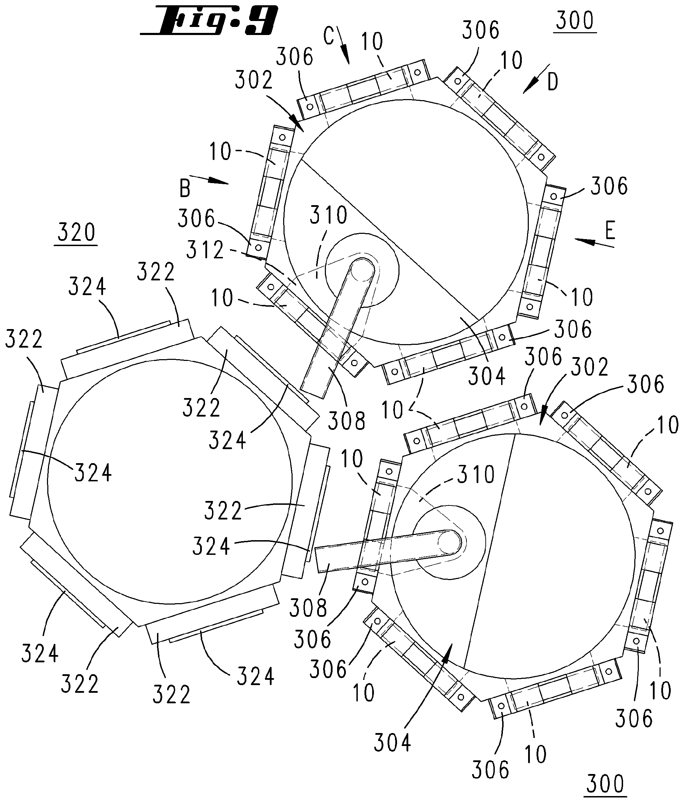

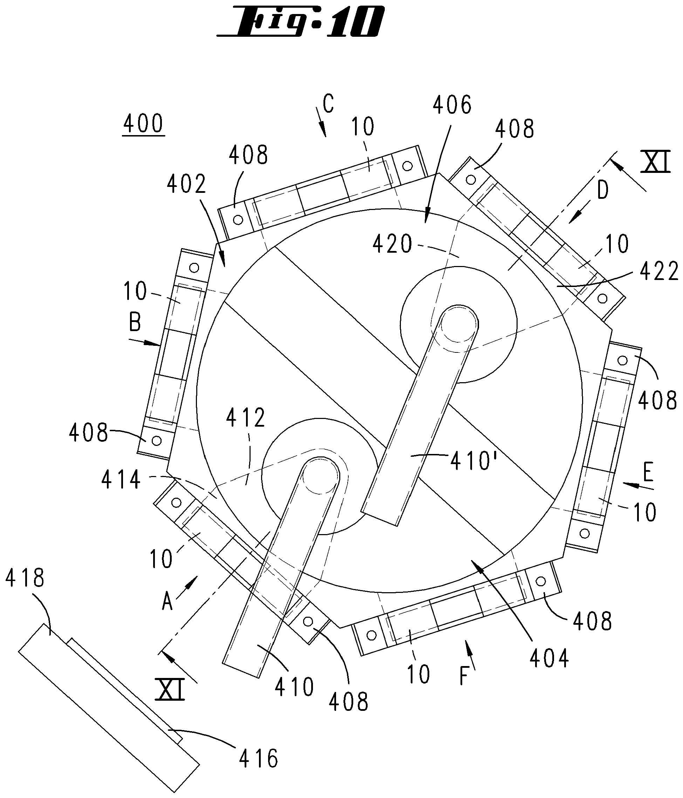

Figure 10 is a top view of an alternative exemplary apparatus to the apparatus shown in Figure 9 wherein multiple condensate coated foam heating elements can be loaded in a deposition system and sequentially heated to generate a material vapor and wherein a controllable carrier gas flow is directed through the active open cell deposition receptacle to acquire the material vapor and deposit a material film on a facing substrate surface. An additional gas flow path is provided to enable in-situ replenishment of the condensate coating within one or more of the then inactive intermediate deposition receptacles.
Figure 11 is a section view through the plane indicated as line VII-VII of the apparatus of Figure 10.
Figure 12 is a perspective view of a second alternative exemplary apparatus to the apparatus shown in Figure 8 wherein multiple condensate coated foam heating elements can be loaded in a deposition system and sequentially heated to generate a material vapor and wherein a controllable carrier gas flow is directed through the active open cell deposition receptacle to acquire the material vapor in the carrier gas. An additional gas flow path is provided to enable in-situ replenishment of the condensate coating within one or more of the then inactive intermediate deposition receptacles.
Figure 13 is a bottom plan view of the second alternative exemplary apparatus of Figure 12 showing the gas flow passages in phantom.
Figure 14 is a section view along the plane XII as shown in Figure 13 additionally including the facing target substrate.
Figure 14A is a perspective view of the apparatus depicted in Figures 12 - 14, shown with a larger target substrate positioned adjacent to the open cell foam heating elements.
Figure 15 depicts a schematic view of an alternative vapor deposition apparatus to the apparatus of Figures 4 and 5 including multiple gas inlets and multiple vapor sources that are mixed and delivered to the first and second open cell heater elements on an as-needed basis.
Figure 15A depicts a cross sectional view of an open cell heating element and accompanying support structure taken along line III-III of Figure 15.
Figure 16 is a depiction of the vapor flux stabilization effect of the apparatus depicted in Figure 15 arising from the action of admitting a vapor to the open cell intermediate deposition receptacle, momentarily condensing the vapor and then evaporating the condensate at a steady vapor flux.
Figure 17 is a schematic depiction of a vapor deposition apparatus for vapor deposition onto substrates transported through a vapor deposition chamber on a conveyor and employing multiple vapor deposition heads.
Figure 18 is a schematic depiction of a vapor deposition apparatus for vapor deposition onto extended length substrates transported through a vapor deposition chamber on a conveyor and employing multiple vapor deposition heads

### DETAILED DESCRIPTION OF THE INVENTION

An improved vaporization process has been developed that eliminates the need for precise powder metering or the use of liquids or pre-processing of the powder to form pellets. This improved vaporization process reduces thermal exposure of the organic material while it eliminates the need for a fast response control system. The design is guided by the observation that the principal factors governing the vaporization or sublimation of a material; temperature, surface area, partial pressure and total pressure are typically only controlled in a general or macro sense. The limited contact between the walls of a crucible and the organic powder it contains, the large thermal gradient that can exist through organic powders, the variation in powder particle size and the local partial and total pressure gradients within a heated mass of powder all contribute to imprecise vaporization control and the need for crucible temperatures in excess of the theoretical value necessary to attain a given deposition rate. The following principles are useful in understanding how the local vaporization conditions can be significantly different from the average vaporization conditions:
First, vaporization rate under high vacuum conditions varies exponentially with the temperature of the organic material. At useful vaporization temperatures for OLED materials, a 1°C change in material temperature can effect a 5% change in vaporization rate.
Second, organic powders are good insulators, especially under high vacuum conditions and those that sublimate are especially difficult to heat by solid conduction once they generate an isolating vapor barrier around the particle. Considering the energy lost to vaporization and the insulating properties of the powder, the effective material temperature can be far lower than the heater temperature and a large thermal gradient can exist through the volume of organic material. Both sources of uncertainty in the organic material temperature lead to uncertainties in the deposition rate. Experiments conducted with AlQ3 and NPB, two well known and well characterized OLED materials, provided evidence that temperatures of the foam ligaments between 160°C and 170°C generate deposition rates normally associated with crucible temperatures of 380°C to 390°C. This several hundred degree lower than expected vaporizer temperature for a given vapor flux was verified by three independent measurement methods.
Third, the melting point of materials having dimensions under 10 nm can be tens to hundreds of degrees lower than the bulk material melting point. The amount of melting point depression increases with decreasing particle size because the surface atoms in a nanometer sized particle have fewer neighboring atoms in close proximity compared to atoms in the bulk of the solid and are therefore bound with less cohesive energy. The cohesive energy of an atom is directly related to the thermal energy required to free the atom from the solid and hence its melting point. The melting point depression observed in nanometer size particles pertains also to thin films and particularly to the first stages of thin film formation where single molecules condense and then coalesce with other molecules into sub nanometer size islands before finally forming a continuous film. This phenomenon is believed to contribute to the unexpectedly low vaporization temperatures observed experimentally.
Fourth, vaporization flux under high vacuum conditions is proportional to the exposed surface area of heated organic material. Increasing the surface area of the organic material can allow a reduction in the temperature required to achieve a given deposition rate.
Fifth, variability in the local deposition rate exists because actual vaporization rate is inversely proportional to the local partial pressure surrounding the powder particles. Adjacent and underlying particles can reduce the theoretical vaporization rate of a given particle either by 1) acting as condensation sites if they are cooler or 2) vaporizing, themselves, effectively driving the local partial pressure toward saturation if the vapor escape is impeded.
Sixth, actual evaporation rate is inversely proportional to the total pressure, and the thickness and density of any boundary layer present. Diffusion through a local boundary layer will slow the local vaporization rate by creating an apparent high partial pressure. A carrier gas can be effective in controlling the deposition rate through its influence on total pressure, boundary layer thickness and partial pressure.

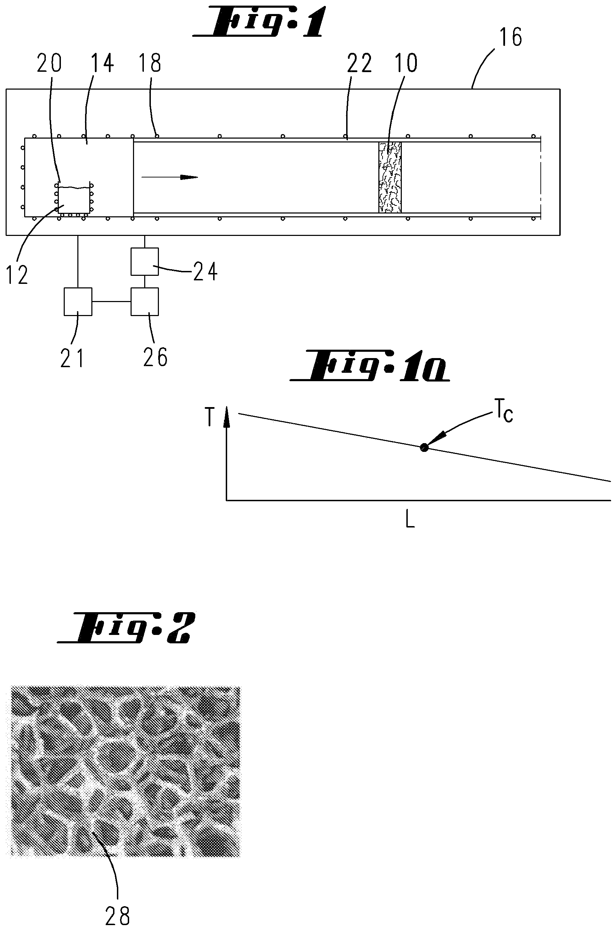

Looking at Figure 1, the invention includes the introduction of one or more open cell foam structures **10** into the center region of a sublimation purification apparatus **11** on whose large surface area is deposited a conformal thin film of the purified organic material condensate. As shown in Figure 1, the material to be purified **12** is loaded in a vaporization apparatus **14** within a vacuum chamber **16** and heated by heating elements **18** to a temperature necessary to produce an effective vaporization rate. The vaporization apparatus **14** may be a simple crucible **20** or may use flash vaporization to vaporize the material with little thermal exposure time. Alternatively, the vaporization apparatus **14** may advantageously utilize the apparatus of this disclosure instead of crucible **20** to vaporize the material to be purified. The vapor is directed to pass through a condensate collection tube **22** having a temperature gradient illustrated in the accompanying graph (see Figure 1A) such that the temperature of condensate collection tube **22** is higher at the end nearest the vaporization apparatus **14** and lower at the opposite end. Intermediate to the two ends of the condensate collection tube **22** is placed one or more open cell foam elements **10** whose temperature is controlled and maintained at a desired condensation temperature Tc such that vapor having the desired molecular structure preferentially condenses on the open cell foam element **10.** The foam element **10** can be placed as in Figure 1 with the face of the one or more foam elements positioned normal to the axis of the condensate collection tube **22** or the foam element **10** can have a polyhedral or tubular shape and be positioned concentric within the condensate collection tube **22.** The foam element **10** can also take the form of flat plates arranged to generally conform to the walls of the condensate collection tube **22.** The vacuum chamber **16** is maintained at a desired pressure by vacuum pump **21** in combination with pressure sensor **24** and pressure controller **26.** Figure 2 is a magnified view of the open cell, polyhedral structure of the foam element **10** composed of interconnected struts or ligaments **28.** Such foam, made from glassy carbon, is commercially available from ERG Aerospace. These foam materials can be coated with metals and ceramics through a chemical deposition process.

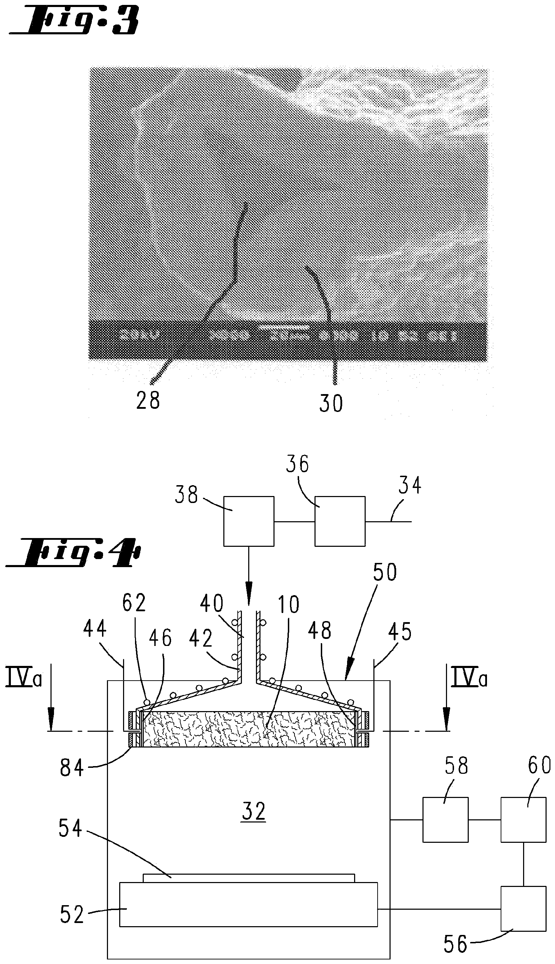

Figure 3 is a highly magnified view of a cross section of a ligament **28** of the foam having a generally triangular shape that is surrounded in this illustration by a very thick coating of condensed material **30.**

Collecting the purified organic material condensate in this manner eliminates the step of removing condensate from the inside of the collection tube in the sublimation purification apparatus and then grinding the condensate to a prescribed particle size and particle size range as is typically done in preparing OLED materials for vapor deposition. The improved method of collecting the condensate directly from the purification sublimation apparatus **11** greatly reduces the health risks of collecting and processing fine powders and additionally eliminates losses and contamination in the removal, grinding and particle sizing processes.

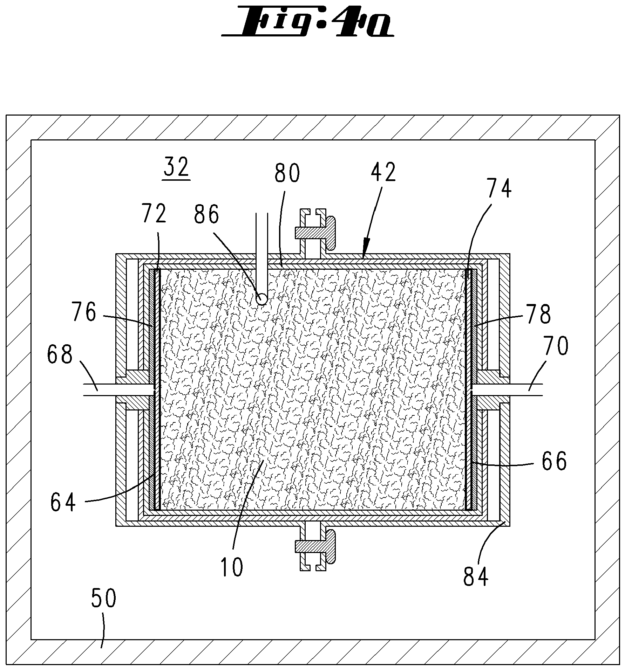

The condensate infused open cell foam element **10** is removed from the sublimation purification apparatus **11** and placed in a vapor deposition apparatus **32** as shown in Figure 4. A carrier gas is directed from an input tube **34** through a mass flow controller **36** and an optional gas heater **38.** The carrier gas enters the deposition apparatus **32** through an input duct **40** and is directed uniformly over the surface of the open cell foam element **10** by a gas distribution manifold or plenum **42.** Electrical energy for heating is brought in to the foam element **10** through wires **44, 45** and contacts **46, 48** such that foam element **10** functions as a heating element. In this manner, the temperature of foam element **10** is controlled to vaporize the material condensed on the surfaces within the open cell foam element **10** at a rate that is well correlated to the pressure inside vacuum chamber **50,** carrier gas flow rate and the temperature of foam element **10** because of the intimate thermal contact between the dense conformal condensate film and the surface of the open cell foam element **10.** A substrate holder **52** controls the temperature of substrate **54** and the interior of the vacuum chamber **50** is maintained at a desired pressure by vacuum pump **56** in combination with pressure sensor **58** and pressure controller **60.** The gas distribution manifold **42** may be heated by heating elements **62** to a temperature sufficient to prevent condensation on the internal surfaces of gas distribution manifold **42** of vapor molecules back diffusing through the carrier gas flow.

Those skilled in the art will recognize that the target, temperature controlled substrate for the embodiments described herein may take many forms. The target substrate would most commonly be a borosilicate glass panel having a thickness between 0.3 and 0.7 mm which is polished on both faces for display applications. For lighting applications which tend to be more sensitive to cost, the target substrate would most commonly be a soda-lime glass panel with a thickness between 0.5 and 1 mm which is polished on at least one face. It is also known to use a flexible substrate made from glass, aluminum or stainless steel foil. These foils are typically between 25 and 100 microns thick. Polymeric substrates such as PET and PEN have also been used after a moisture barrier film coating has been first deposited as a support layer for the OLED material.

Looking at Figure **4A****,** there is shown a cross section view of vapor deposition apparatus **32.** Heater **10** is sandwiched between electrodes **64, 66.** The electrodes **64, 66** are preferably a conductive metal foil, and current flows through electrodes **64, 66** to the ligaments of heater **10** to cause heat to be produced. Electrical cable leads **68, 70** connect to electrodes **64** and **66,** respectively. Electrodes **64, 66** preferably take the form of conductive foils. A variety of metals can be used for the electrodes **64, 66.** Conveniently, titanium, tantalum, tungsten, or molybdenum or coatings of these materials on softer metals such as copper or silver can be used due to their relative chemical inertness at elevated temperatures. Compliant elements **72, 74** are heat resistant and optionally thermally conductive material. Compliant elements **72, 74** can conform to the surface texture of heater **10** and create local deformation of conductive foils **64, 66** when the heater **10** is pressed against the compliantly supported conductive foils **64, 66.** One example of useful compliant material is GRAFOIL®. UCAR Carbon Company Inc. of Wilmington, DE., manufactures GRAFOIL® Flexible Graphite as a rolled sheet product that exhibits good heat resistance and typically exceeds 97% elemental carbon by weight.

The sandwich configuration shown in Figure **4A** provides low contact resistance between the heater **10** and the conductive foils **64** and **66,** insuring that at least 90 percent of the heat is generated in the ligaments of heater **10** instead of at the interface between the electrodes **64, 66** and the heater **10.** Nano-particulate silver paint can also be used to lower the electrical contact resistance between the electrodes **64, 66** and the carbon foam material of the heater **10.** Because the silver particles are of a nanometer size, they soften and melt at temperatures hundreds of degrees less that the melting temperature of bulk silver. This behavior is very size dependent and facilitates the establishment of excellent electrical contact between the electrodes **64, 66** and the carbon foam material of the heater **10.** The heater **10** and foils **64, 66** and compliant elements **72, 74** are clamped together by contacts **76, 78.** Contacts **76, 78** may be electrically conductive and be attached to electrodes **64, 66,** respectively to carry current to the heater **10.** Alternately, the contacts **76, 78** could be electrical insulators or have an electrically insulating coating but act as thermal conductors to cool heater **10.** Isolating element **80** electrically and thermally isolates the heating structure from the vapor manifold or plenum **42** and the entire assembly is unitized by clamping structure **84.** A thermocouple **86** or infrared sensor can be used to measure the temperature of heater **10** and provide feedback to control the current delivered to heater **10.** It is also possible to measure the voltage and current delivered to heater **10** as a function of temperature to determine the effective electrical resistance. Most materials have a measurable temperature coefficient of resistance and after calibration; it is possible to infer the average heater temperature based on the effective resistance.

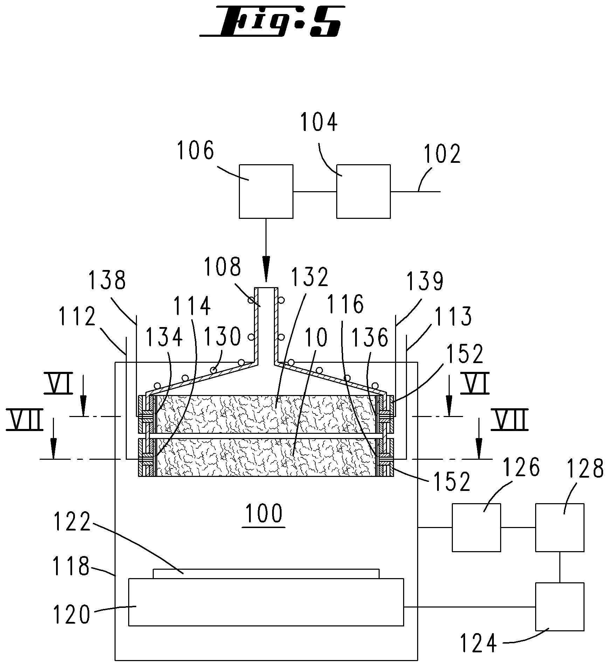

Figure 5 depicts an alternative vapor deposition apparatus **100** similar to the apparatus **32** shown in Figure 4. A carrier gas is directed from an input tube **102** through a mass flow controller **104** and an optional gas heater **106.** The carrier gas enters the vapor deposition apparatus **100** through an input duct **108** and is directed uniformly over the surface of the open cell foam element **10** by a gas distribution manifold or plenum **110.** Electrical energy for heating is brought in to the foam element **10** through wires **112, 113** and contacts **114, 116** such that foam element **10** functions as a heater. In this manner, the temperature of foam element **10** is controlled to vaporize the material condensed on the surfaces within the open cell foam element **10** at a rate that is well correlated to the pressure within vacuum chamber **118,** carrier gas flow rate and the foam temperature because of the intimate thermal contact between the dense conformal condensate film and the surface of the open cell foam element **10.** A substrate holder **120** controls the temperature of substrate **122** and the interior of the vacuum chamber **118** is maintained at a desired pressure by vacuum pump **124** in combination with pressure sensor **126** and pressure controller **128.** The gas distribution manifold or plenum **110** may be heated by heating elements **130** to a temperature sufficient to prevent condensation on its internal surfaces of vapor molecules back diffusing through the carrier gas flow. In this embodiment, the gas distribution function within gas distribution plenum **110** is accomplished with a second open cell foam structure or heating element **132** similar or identical to the open cell foam element **10** used to re-vaporize the condensed material. However, second open cell foam structure or element **132** does not have vapor deposition coating thereon. Instead of acting as a source of vapor deposition material in the vapor deposition process, second open cell foam structure **132** serves to evenly distribute the carrier gas across the upstream face of the open cell foam element **10.** The open cell foam structure **132** may be heated by passing electrical current through contacts **134, 136** and current delivery wires **138, 139.** As such, second open cell foam structure **132** may optionally be used to preheat the carrier gas. The combination of the gas distribution manifold **110,** heating elements **130,** and an optional gas heater **106,** input duct **108,** wires **112** and contacts **114** and **116,** along with the open cell heating elements **10, 132** may be referred to herein as a vapor deposition head **140.** Open cell foam structures are well known to randomly change the direction of a steady flow of gasses passing through them and thereby produce a spatially uniform output flow over the entire area of the output face of the foam even when the input flow is focused over less than 1 percent of the area of the input face of the foam. The configuration shown in Figure 5 is especially advantageous in that a single open cell foam element **132** provides uniform carrier gas flow to the heating and vaporizing open cell foam element **10,** can provide heating of the carrier gas, and can be heated to a controlled temperature to prevent condensation on its surfaces as well as the surfaces of the gas distribution manifold **110** from vapor molecules generated from open cell foam element **10** that back diffuse through the carrier gas flow. This method achieves precise vapor deposition rates based on heater temperature and carrier gas flow without the need to accurately prepare and dispense powders, without the need to introduce liquids, and without the need for a fast response control system. In working with a condensate film as opposed to powders, this method additionally reduces the exposed surface area of the organic material that can be subject to infiltration of water vapor and other contaminants. When the organic material infused in the open cell foam is exhausted, a new foam element with a fresh charge of organic material may be introduced.

Three dimensional, open cell reticulated foam structures are commercially available having 90 to 97% open porosity. In these open cell reticulated foams, only the edges of the polyhedral shaped cells remain. The edges of the cells or ligaments most often have a generally triangular cross section and collectively present a large surface area relative to the volume of the foam. A one micron thick organic condensate enveloping each ligament in 250 cm³ of foam volume would constitute 1 gram of condensed organic material. Relative to systems vaporizing powders, the intimate mechanical contact between the conformal condensed organic film and the ligaments in the open cell foam structure provides superior temperature uniformity and heat transfer to the entirety of the organic material as well as improved control and correlation between the temperature of the ligaments and the vaporization rate of the organic material.

The open cell foam can be made from glassy carbon, for example, and therefore can be used as a responsive electrical resistance heater because it is electrically conductive. Further, the very low mass of the open cell foam allows for a very fast heating response. While glassy carbon is relatively inert, refractory metals (e.g. niobium, tantalum, tungsten, molybdenum, and rhenium), inert metals (e.g. gold and platinum), and ceramic compounds (e.g. the oxides, nitrides, carbides, borides, and silicides of the metals) may be deposited over the glassy carbon structure by CVD to produce a conformal coating, retaining the resistance heating characteristics of the glassy carbon while improving the thermal conductivity, the mechanical strength and the maximum service temperature of the foam in air. By introducing a coating on the glassy carbon, it is also possible to control the emissivity of the foam element to, for example, minimize the energy absorbed and emitted through thermal radiation. A perspective view of a section of the foam structure is depicted in Figure 2.

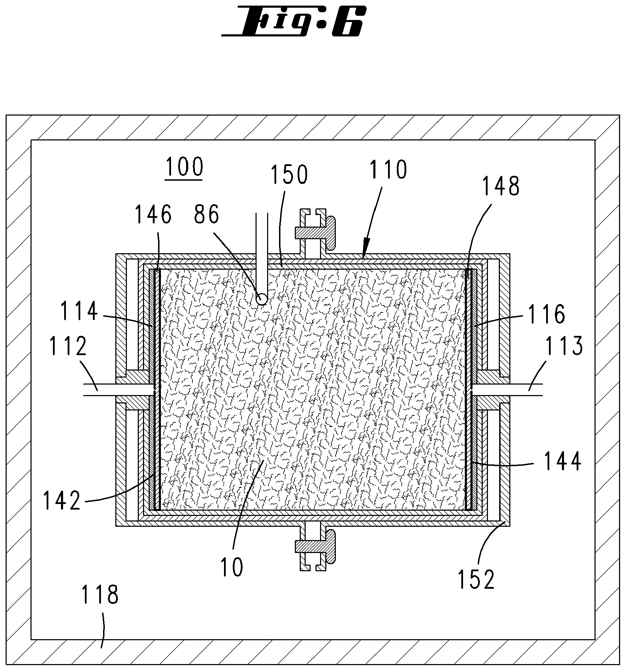

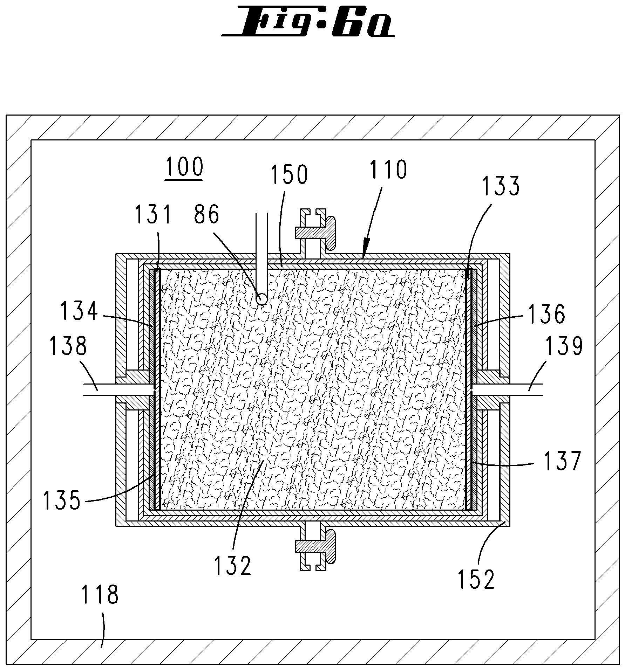

Looking at Figure **6****,** there shown a cross section view of vapor deposition apparatus **100** passing along line IV - IV in Figure 5 through heater **10.** A parallel cross section through heater **132** in Figure 5 along line V-V is shown in Figure 6A. Both Figures 6 and 6A show identical functional elements to those shown in Figure 4A. Heater **10** is sandwiched between electrodes **142, 144.** The electrodes **142, 144** are made of a conductive metal foil, and electrical current flows through the electrodes **142, 144** to the ligaments of heater **10** through electrodes **142, 144** to cause resistance heat to be produced in the ligaments. Electrical cable leads or wires **112, 113** connect to electrodes **142, 144,** respectively. Electrodes **142, 144** preferably take the form of conductive foils. A variety of metals can be used for the electrodes **142, 144.** Conveniently, titanium, tantalum, tungsten, or molybdenum or coatings of these materials on softer metals such as copper or silver can be used due to their relative chemical inertness at elevated temperatures. Compliant elements **146, 148** are heat resistant and, optionally, thermally conductive material. Compliant elements **146, 148** can conform to the surface texture of heater **10** and create local deformation of electrodes **142, 144** when the heater **10** is pressed against the compliantly supported **142, 144.** One example of useful compliant material is GRAFOIL®. UCAR Carbon Company Inc. of Wilmington, DE., manufactures GRAFOIL® Flexible Graphite as a rolled sheet product that exhibits good heat resistance and typically exceeds 97% elemental carbon by weight.

The sandwich configuration shown in Figure **6** provides low contact resistance between the heater **10** and the electrodes **142, 144,** insuring that at least 90 percent of the heat is generated in the ligaments of heater **10** instead of at the interface between the **142, 144** and the heater **10.** Nano-particulate silver paint can also be used to lower the electrical contact resistance between the electrodes **142, 144** and the carbon foam material of the heater **10.** Because the silver particles are of a nanometer size, they soften and melt at temperatures hundreds of degrees less that the melting temperature of bulk silver. This behavior is very size dependent and facilitates the establishment of excellent electrical contact between the electrodes **142, 144** and the carbon foam material of the heater **10.** The heater **10** and foils **142, 144** and compliant elements **146, 148** are clamped together by contacts **114, 116.** Contacts **114, 116** may be electrically conductive and be attached to electrodes **142, 144,** respectively to carry current to the heater **10.** Alternately, the contacts **114, 116** could be electrical insulators or have an electrically insulating coating but act as thermal conductors to cool heater **10.** Isolating element **150** electrically and thermally isolates the heating structure from the plenum **110** and the entire assembly is unitized by clamping structure **152.** A thermocouple **86** or infrared sensor can be used to measure the temperature of heater **10** and provide feedback to control the current delivered to heater **10.** It is also possible to measure the voltage and current delivered to heater **10** as a function of temperature to determine the effective electrical resistance. Most materials have a measurable temperature coefficient of resistance and after calibration; it is possible to infer the average heater temperature based on the effective resistance.

In Figure 6A, electrical cable leads or wires **138, 139** connect to electrodes **135, 137,** respectively. Electrodes **135, 137** preferably take the form of conductive foils. A variety of metals can be used for the electrodes **135, 137.** Conveniently, titanium, tantalum, tungsten, or molybdenum or coatings of these materials on softer metals such as copper or silver can be used due to their relative chemical inertness at elevated temperatures. Compliant elements **131, 133** are heat resistant and, optionally, thermally conductive material. Compliant elements **131, 133** can conform to the surface texture of heater **132** and create local deformation of electrodes **135, 137** when the heater **10** is pressed against the compliantly supported **131, 133.** One example of useful compliant material is GRAFOIL®. UCAR Carbon Company Inc. of Wilmington, DE., manufactures GRAFOIL® Flexible Graphite as a rolled sheet product that exhibits good heat resistance and typically exceeds 97% elemental carbon by weight.

The vaporization rate of the organic material from the three-dimensional, open cell, reticulated element is essentially constant over a wide range of condensed material mass within the foam structure but varies as a function of the temperature of the three-dimensional, open cell, reticulated element, as a function of the chamber pressure and as a function of the carrier gas flow rate. The large interaction surface area between the organic material and the open cell foam heater and the intimate and uniform thermal contact with the entirety of the conformal organic material coating greatly increase the vapor flux generated for a given temperature of the foam heater structure. In addition, the over 90% open porosity of the foam structure provides a low resistance flow path for the vapor to escape from the foam structure and for an inert carrier gas to further assist in evacuating the organic vapor from the foam. Allowing the free escape of organic vapor from the condensate surface and optionally facilitating the escape with the use of a carrier gas fosters a low partial pressure environment at the condensate surface that further improves the vaporization rate for a given heater temperature. Because the decomposition of organic materials is strongly correlated with temperature, a reduction of the vapor generator source temperature by 50°C or more, as has been demonstrated with the device of this disclosure for a given vapor flux, provides a substantial reduction in the decomposition of organic materials. The disclosed geometry enables precise control of the temperature, the partial pressure, and the total pressure over virtually the entire volume of organic material at a very local level. The temperature of the inert carrier gas can be the same or different from that of the foam material. If the carrier gas is cooler than the foam material, it is possible to effect cooling of the foam and therefore provide the capability to rapidly interrupt, initiate or modify the vaporization rate of the organic material. If the carrier gas is hotter than the foam, it can be used to provide at least part of the vaporization energy and again interrupt, initiate or modify the deposition rate based on the gas flow rate. It is further possible for the carrier gas to be a mixture of an inert gas and an organic vapor such that the flow exiting the foam consists of multiple organic material vapors.

The flow rate of the carrier gas and its effect on the local pressure provide greater control of the deposition rate than is attainable by temperature control alone. Recalling that the vaporization rate varies exponentially with temperature, a 1°C temperature change can effect a 5% deposition rate change but over some range, the deposition rate varies nearly linearly with the flow rate of a carrier gas.

It can be shown that a 20 nm thick film on a fifth generation substrate (1.43 m² surface area) contains only 36 milligrams of organic material, and that 1 gram of condensed organic material infused in each 250 cm³ of foam volume per micron of condensate thickness can be used to coat at least 12, fifth generation size substrates, even with a deposition efficiency of only 50%. A one micron condensate thickness adds less than a 10 PPM change to the surface area of a 250 cm³ volume of open cell foam, allowing excellent deposition rate stability for a given foam temperature even as the organic material is consumed. For a high throughput application, producing 2000 m² of coated substrates per day, the amount of organic material deposited per layer on average is 50 grams per day. If the deposition efficiency is greater than 50%, the daily required organic condensate volume could be infused in a foam block measuring 30 cm x 30 cm x 5 cm thick.

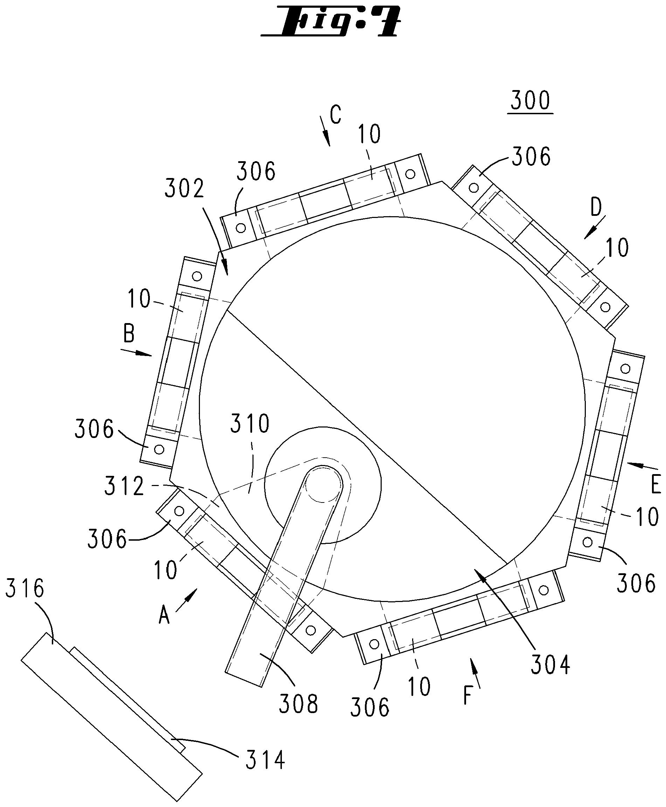

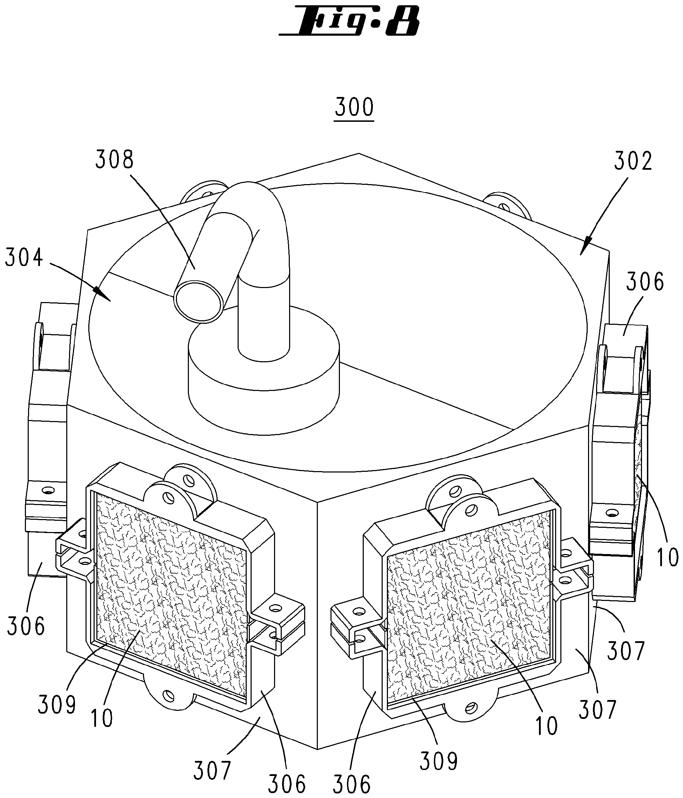

Multiple operating modes are possible. For example, multiple condensate coated or infused foam heating elements **10** (as described with reference to Figures 1, 4, 4A, and 6) can be loaded in a deposition source supply head **300,** shown in Figures **7** and **8****,** and sequentially heated to generate vapor and thereby enable longer deposition periods than would be practical with a single foam element. The deposition source supply head **300** comprises a rotor **302** and a stator **304** that can rotate one relative to the other. In one embodiment, the rotor **302** rotates about the stator **304** and in another embodiment; the stator **304** rotates within the rotor **302.** The deposition source supply head **300** shown in this exemplary embodiment is a hexagonal prism and includes a frame **306** mounted each face **307** thereof. In each frame **306** is supported a condensate coated or infused foam heating element **10.** Heating element **10** is supported within frame **306** similar to the how the heating element **10** is supported within frame or clamping structure **152** as depicted in Figure 6. For purposes of brevity, the electrodes, electrical cable leads, compliant elements, contacts, electrical isolating element, and vapor manifold described with reference to Figure 6 are not shown in or described with reference to Figures 7 and 8 (with the exception of a single contact **309** which is visible in Figure 8). However, those skilled in the art will recognize the need for such elements to be present so that heating element 10 can actually function as a heater. An inert carrier gas flowing through feed tube **308** enters duct **310** in stator **304** that is in rotatable but gas sealing cooperation with rotor **302.** The inert carrier gas passes through duct **312** in rotor **302** and is distributed uniformly over the surface of the active open cell foam heating element **10.** The carrier gas mixes with the vapor generated within open cell foam heating element **10** upon heating and is transported to a substrate **314** supported on a temperature controlled substrate holder **316** where the vapor condenses to deposit a controlled thickness film. The deposition source supply head **300** is rotatable such that each heating element **10** on rotor **302** may be positioned to align with duct **310** in stator **304** such that gas flows from feed tube **308,** into duct **310,** then duct **312** and through the aligned heating element **10.** The carrier gas mixes with the vapor generated by evaporating material within heating element **10,** the mixture passes into a deposition chamber (not shown) containing the target substrate **314** and the vapor condenses on the surface of the target substrate **314.** Figure 8 shows a perspective view of the deposition source supply head. While each face **307** of rotor **302** is depicted as being planar, and each heating element **10** is depicted as having planar surfaces, those skilled in the art will understand that the support faces **307** may have other shapes. For example, each heating element **10** may take a curvilinear form, and support faces **307,** or the frames **306,** or both may be either or at least adapted to receive curvilinear heating elements. In this manner, the apparatus can be adapted to vapor deposit onto substrates that curved or non-planar surfaces. Alternatively, each of the condensate infused heating elements **10** can contain a different vaporizable material such that a single substrate **314** sequentially receives coatings of different materials as rotor **302** carries different condensate infused heating elements **10** into alignment with carrier gas duct **312** and substrate **314.**

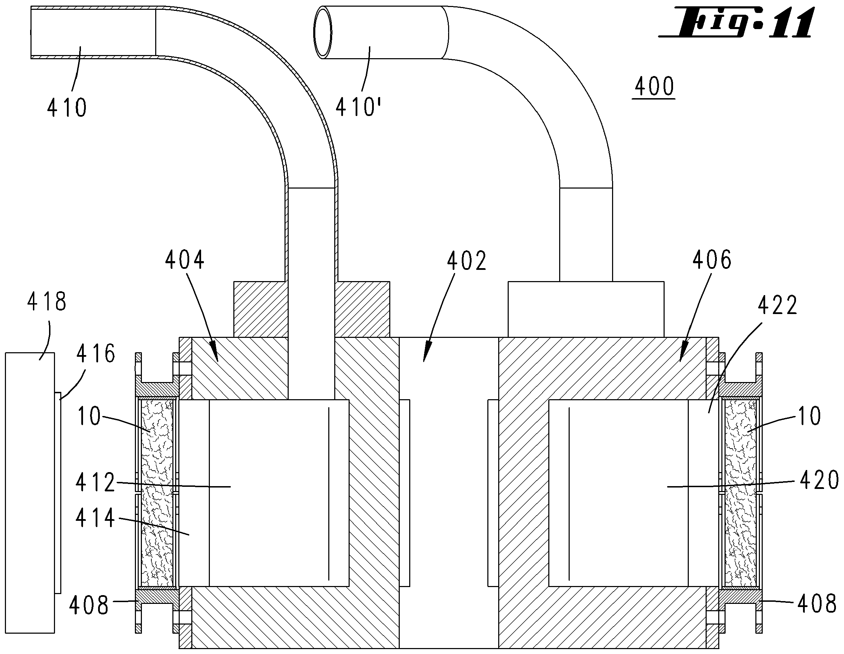

One skilled in the art will appreciate that a rotatable multi-faceted prism **320** as shown in Figure 9 can be used in combination with one or more deposition source supply heads **300.** A substrate holder **322** and a target substrate **324** can be mounted on each face of a rotatable multi-faceted prism **320** and be rotated into facing alignment with one of several condensate infused heating elements **10** on one or more deposition heads **300** such that single or multiple film depositions can be accomplished in a continuous manner on successive substrates 324. The apparatus shown in Figure 9 could, for example, deposit twelve different layers on a continuous succession of substrates. In this embodiment, a single gas feed tube **308,** stator **304** and duct **310** are shown in deposition heads **300** but one skilled in the art will understand that multiple gas feed tubes, stators, and ducts can be arranged within rotor **302,** each in fluid communication with a different condensate infused heating element **10,** to simultaneously evaporate infused, vaporizable material on multiple substrates simultaneously. If there were multiple, multi-faceted prisms 320 holding substrates arranged around one deposition source supply head having multiple gas feed tubes then multiple substrates (on different substrate holding prisms) could receive coatings simultaneously. The substrate holding prisms could remain stationary while a single deposition head sequenced through six different materials on its six faces to build six layer film stacks on one of the substrates per substrate holding prism. Alternately, the deposition head could remain stationary while the multiple substrate holding prisms sequenced through their six substrates each to deposit the same material on each of the six substrates before the deposition head is rotated to begin depositing a new material on each of the six substrates. It is also possible to recharge expended and idle foam heating elements **10** with condensate in-situ as shown in Figure 10. In this embodiment, multiple condensate coated or infused foam heating elements **10** can be loaded in a deposition source supply head **400,** shown top view in Figure 10. These heating elements **10** can be sequentially heated to generate vapor and thereby enable longer deposition periods than would be practical with a single foam element. The deposition source supply head **400** comprises a rotor **402** and stator portions **404, 406** that can rotate one relative to the other. In one embodiment, the rotor **402** rotates about stator portions **404, 406** and in another embodiment; the stator portions **404, 406** rotate within rotor **402.** The deposition source supply head **400** shown in this exemplary embodiment is a hexagonal prism and includes a frame **408** mounted each face thereof. Frames **408** are identical to frames **306** described with reference to Figure 7. In each frame **408** is supported a at least one condensate coated or infused foam heating elements **10.** Heating elements 10 is supported within frames 408 similar to the how the heating element 10 is supported within frame 22 as depicted in Figure 6. For purposes of brevity, the electrodes, electrical cable leads, compliant elements, contacts, electrical isolating element, and vapor manifold described with reference to Figure 6 are not shown in or described with reference to Figures 10 and 11. However, those skilled in the art will recognize the need for such elements to be present so that heating element 10 can actually function as a heater. An inert carrier gas flowing through feed tube **410** enters duct **412** in stator portion **404** that is in rotatable but gas sealing cooperation with rotor **402.** The inert carrier gas passes through duct **414** in rotor **402** and is distributed uniformly over the surface of the active open cell foam heating element **10.** The carrier gas mixes with the vapor generated within open cell foam heating element **10** and is transported to a substrate **416** supported on a substrate support **418** contained within a deposition chamber (not shown) where the vapor condenses to deposit a controlled thickness film. The deposition source supply head **400** is rotatable such that each heating element **10** on rotor **402** may be positioned to align with a duct **412** in stator portion **404** such that gas flows from feed tube **410,** into duct **412,** then duct **414** and through the selected aligned heating element **10.** The carrier gas mixes with the vapor generated by evaporating material within heating element **10,** the mixture passes into a deposition chamber (not shown) containing the target substrate **416** and the vapor condenses on the surface of the substrate **416.**

In the embodiment shown in Figure 10, a replenishment vapor flux is generated from a second vapor source (not shown), passes through feed tube **410** and into duct **420** in stator portion **406** that is in rotatable but gas sealing cooperation with rotor **402.** The replenishment vapor passes through duct **422** in rotor **402** and is dispersed uniformly into the volume of the foam heating element **10** (being maintained at a temperature that will promote condensation of the replenishment vapor). As the replenishment vapor expands into the lower temperature and pressure region within the foam, it cools and the vapor condenses on the cooler ligaments of the foam to form a solid coating thereon. The foam acts as a condensate accumulator, storing enough organic material in the solid state to subsequently coat many substrates. The addition of a replenishment vapor flux in the apparatus shown in Figure 10 can maintain the deposition function of the apparatus as a source of vaporized material indefinitely. In this embodiment, it is not necessary for the replenishment vapor source to have a particularly steady or controlled vapor flux.

Figure 11 shows a cross section through the apparatus of Figure 10 along the plane VII to more clearly illustrate the vapor path through the apparatus. The rotor **402** is rotated to align a selected heating element **10** supported within a frame **408** with ducts **412, 414** so that deposition vapor can be generated in the selected heating element **10** and transmitted to a target substrate **416.** Similarly, rotor **402** is rotated to align a selected heating element **10** supported within a frame **408** with ducts **420, 422** so that replenishment vapor can be delivered to a spent heating element **10** to re-coat the spent heating element with a coating of the deposition material. After the spent heating element **10** has been re-charged with vapor deposition material, it can be rotated back into a position of alignment with ducts **412, 414.**

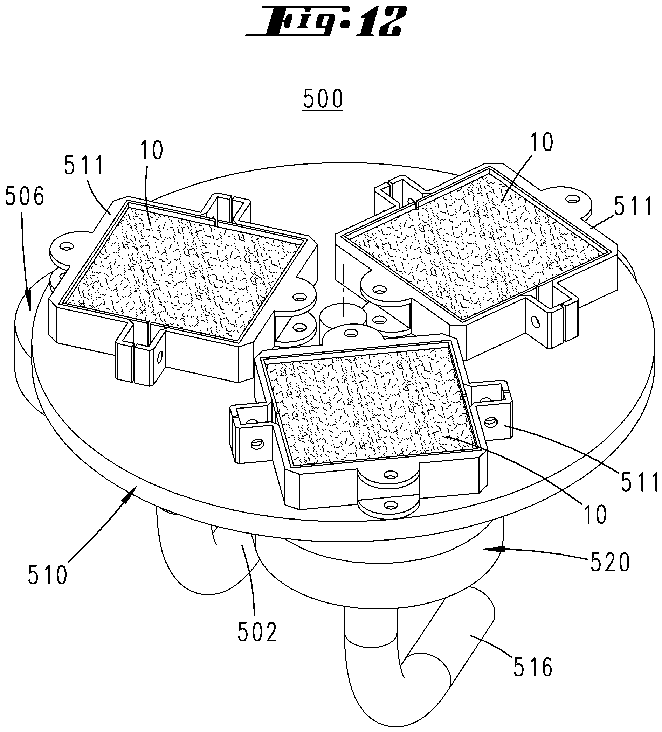

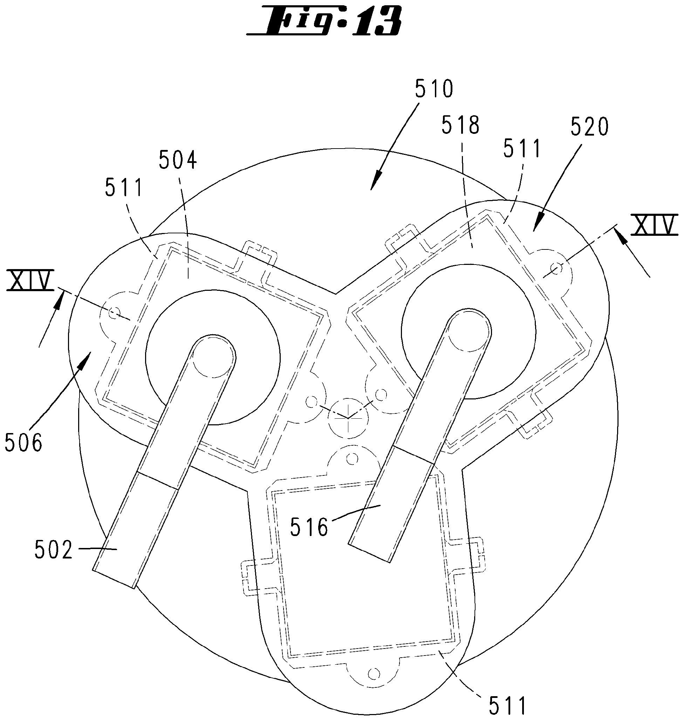

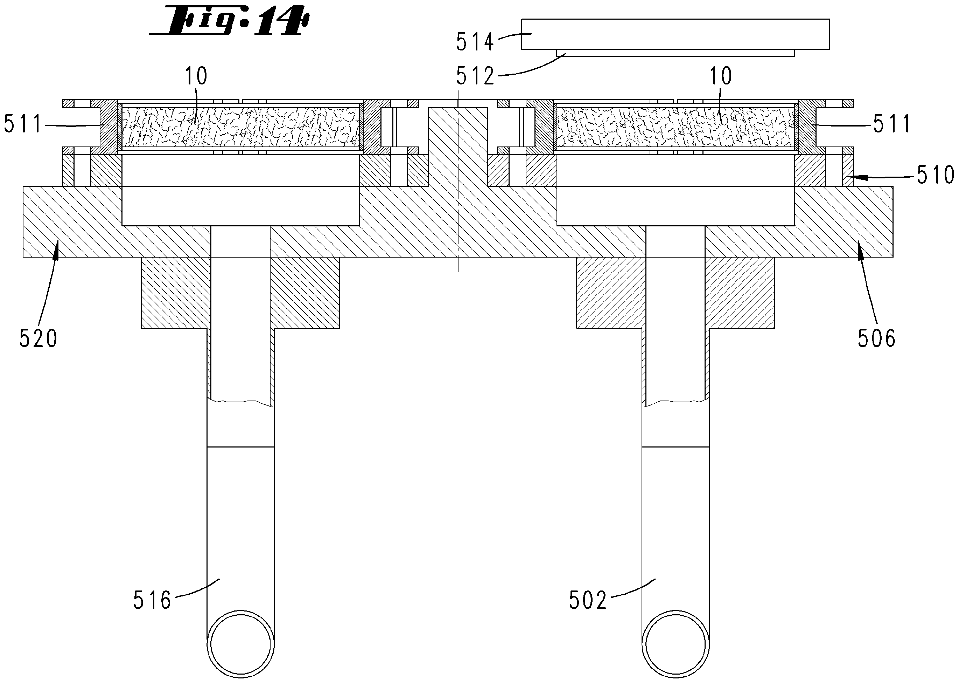

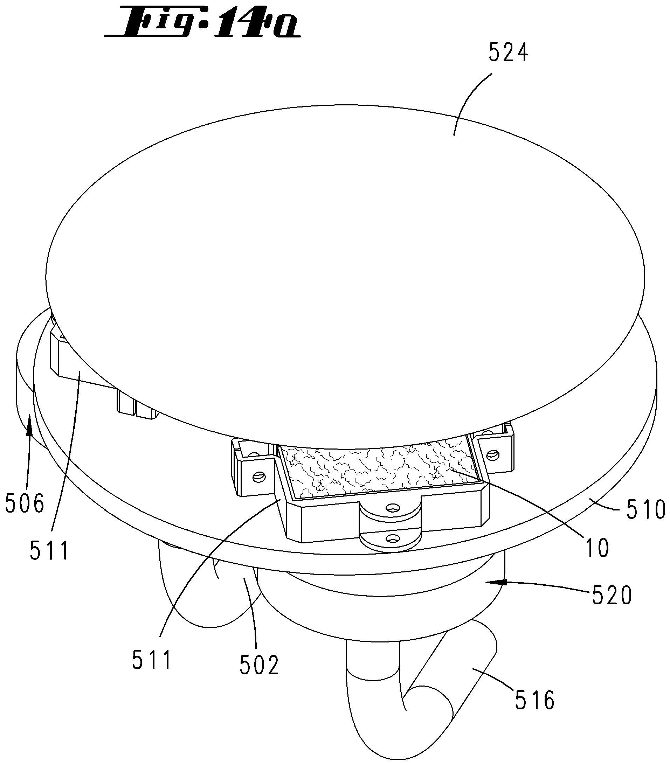

An alternate, exemplary vapor deposition apparatus including a vapor deposition head **500** is shown in Figures 12, 13 and 14 which is similarly capable of sequentially heating and vaporizing material from one or more open cell foam elements **10** and which is capable of having a separate station to replenish the condensate coating on the one or more exhausted open cell foam elements. A controlled carrier gas flows through feed tube **502** and into duct **504** in stator portion **506.** The carrier gas passes through duct **508** in rotor **510** and mixes with material vaporized in open cell foam heating element **10.** The material vapor then condenses on the surface of substrate **512** supported on substrate holder **514** (shown in Figure 14) in facing alignment to foam heating element **10** individually supported with a respective frame **511** attached to rotor **510.** A replenishment vapor of selected vapor deposition material may be admitted through feed tube **516** and into duct **518** in stator portion **520.** The replenishment vapor then passes through duct **522** in rotor **510** and condenses on the ligaments of open cell foam heating element **10** then aligned with duct **518.** This configuration shares all of the functional capabilities of the apparatus shown in Figures 7 and 10 in that multiple material infused foam heating elements 10 may be sequentially heated to generate a material vapor that mixes with a carrier gas for deposition on a substrate **512** in facing alignment analogous to the functionality of the apparatus shown in Figure 7; the one or more substrate holders **514** supporting respective substrates **512** may themselves be supported on a rotatable table (not shown) allowing one or more deposition heads **500** to simultaneously deposit material on substrates **512** supported by one or more substrate support tables analogous to the functionality of the apparatus shown in Figure 9, and a replenishment vapor of a selected vapor deposition material can be introduced to replenish deposition material in expended foam elements **10** positioned outside of active deposition positions analogous to the functionality of the apparatus shown in Figure 10.

This configuration can enable additional functionality however when each of the foam heating elements **10** is used simultaneously to generate material vapors that mix with separate carrier gas flows to deposit a mixture of materials on a facing substrate surface. The multiple foam elements **10** may remain stationary relative to the target substrate during the deposition process and rely on gas mixing to create a spatially uniform material concentration in the deposited film or may additionally utilize rotational, translation or other relative motion between the foam heating elements **10** and the substrate to create the desired material concentration uniformity over the surface of the substrate. This mode of operation can most easily be visualized from Figure 14A for a substrate **524** having dimensions slightly smaller than rotor **510** that is located with its center concentric with the axis of rotor **510** and a short distance off-spaced from foam heating elements **10.** [A rotary coupling could be used to communicate multiple gas flows from stationary gas sources to the multiple rotating foam heating elements. In this configuration, each of the three (in this case) foam heating elements can evaporate a different organic material at different evaporation rates to provide a film on the stationary substrate that is a controlled mixture of the three organic materials. Three separate gas feed tubes would be used in this example. Both the rotor and stator would rotate together in this embodiment so that the carrier gas continues to flow to its respective foam element. Further, those skilled in the art will recognize that the substrate may be rotated as an alternative to rotating the foam elements, . Typically the substrate must be temperature controlled and this would similarly require a rotary coupling for the coolant flow.

Experimentally, foam having a pore cell size of approximately 1 mm and a thickness in the vapor flow direction of 1 cm. proved effective in storing and releasing organic vapors when heated to temperatures between 100°C and 200°C in a vacuum chamber under a range of pressures from 10 to 200 Pa. In addition to demonstrating the suitability of the open cell foam as a means of re-evaporating a condensate coating, an experiment was conducted to determine if a replenishment vapor could be continuously delivered to a foam element that was actively generating a vapor flux. These experiments demonstrated that it is possible, by varying the temperature profile in the flow direction through a 1 cm thick open cell foam element, to use the foam element as a vapor selective sieve or valve. In a first temperature condition, the foam allows the free passage of replenishment vapor molecules through, as well as the generation of vapor from condensate within the foam. In a second temperature condition, the foam prevents the passage of more than a fraction of 1 percent of replenishment vapor molecules and inhibits the generation of vapor from condensate within the foam. In both of these conditions, the carrier gas flows through the foam virtually unimpeded. This behavior as a vapor selective sieve is observed even though there is sufficient open area to allow an observer to "see" through the foam element. In this pressure and temperature range, the mean free path, defined as the average distance a molecule travels before colliding with another molecule is smaller but on the same order of magnitude as the average pore size in the foam. It is believed that the short collision distance due to the mean free path to pore size correlation explains why the percentage of vapor molecules passing through the foam unimpeded is nearly zero and is much smaller than would be expected from the large line-of-sight open area. The ability to selectively allow or prevent the passage of vapor while offering nearly no resistance to the flow of the carrier gas is important to the operation of carrier gas assisted deposition systems from two perspectives. From a first perspective, it is useful to be able to switch the incoming vapor flow off when the desired film thickness has been deposited on the substrate and to do so without disturbing the carrier gas flow and therefore the pressure in the deposition chamber. The vapor typically represents only a few percent of the total gas flow but the deposited film thickness signal from the crystal rate monitor is strongly influenced by changes in its ambient pressure. By selectively inhibiting only the vapor flow, it is possible to maintain a constant chamber pressure and therefore a reliable film thickness monitor reading. From a second perspective, after passing over the substrate, the carrier gas must be exhausted and there is always some vapor in the exhaust gas downstream of the substrate. It is useful to capture this residual vapor to prevent unwanted deposition in the exhaust system and to do so without significantly impeding the flow of the exhaust carrier gas.

Although the first 1 cm thick foam element experiment failed to demonstrate the ability to generate a steady re-evaporated vapor flux that is completely independent from a concurrent replenishment vapor flux, it demonstrated that the open cell foam is a much more effective vapor sieve than its visual appearance would suggest.

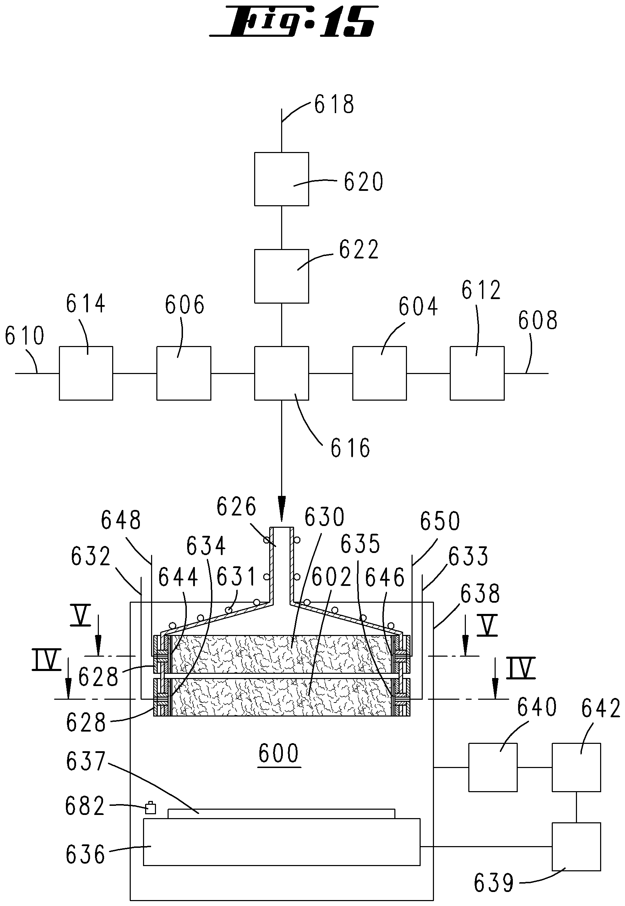

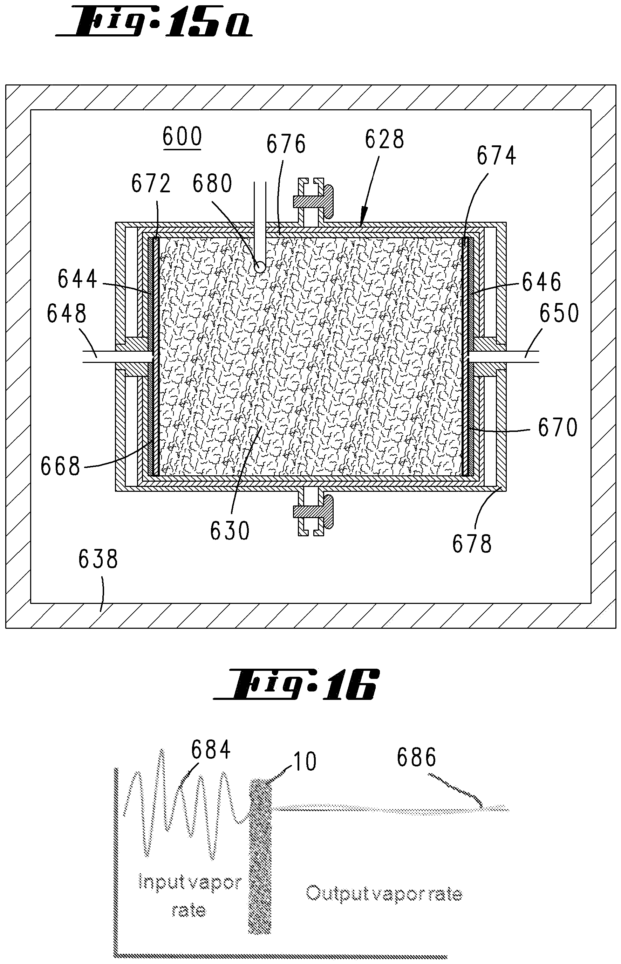

There is shown in Figure 15 an alternative embodiment vapor deposition apparatus **600** in which replenishment of the coating on the open cell foam element **602** is performed in situ. A continuous flow of replenishment vapor from one or more vapor generator sources **604, 606,** each with a respective carrier gas inlet **608, 610,** and a respective gas flow controllers **612, 614** is directed to a vapor mixer **616** having an optional dilution carrier gas inlet **618,** a gas flow controller **620** and gas temperature controller **622.** From the vapor mixer **616,** the gas mixture is transmitted through conduit **624** into gas inlet tube **626** of gas distribution manifold or plenum **628.** Open cell foam structures **602, 630** reside within gas distribution manifold or plenum **628** which may be heated by heating elements **631** to a temperature sufficient to prevent condensation on the internal surfaces of gas distribution manifold or plenum **628** of vapor molecules back diffusing through the carrier gas flow. Electrical energy for heating is brought in to the foam elements **602, 630,** through wires **632, 633** and contacts **634, 635** such that foam elements 602, 630 function as heaters. The gas flow is directed to uniformly flow into the foam structures or elements **602, 630** and condense uniformly on the ligaments of the foam structures **602, 630.** Foam structures **602, 630** are essentially the same as the open cell foam element **10** depicted in and discussed with reference to previous Figures with the exception that open cell foam heating element **630** does not have a coating of a vapor deposition material deposited thereon.

A substrate holder **636** controls the temperature of substrate **637** and the interior of the vacuum chamber **638** is maintained at a desired pressure by vacuum pump **639** in combination with pressure sensor **640** and pressure controller **642.** In this embodiment, the gas distribution function within plenum **628** is accomplished with the second open cell foam structure or element **630** similar or identical to the open cell foam element **602** used to re-vaporize the condensed material. However, second open cell foam structure or element **630** does not have vapor deposition coating thereon. Instead of acting as a source of vapor deposition material in the vapor deposition process, second open cell foam structure **630** serves to evenly distribute the carrier gas across the upstream face of the open cell foam element **602.** The open cell foam structure **630** may be heated by passing electrical current through contacts **644, 646** and current delivery wires **648, 650.** As such, second open cell foam structure **630** may optionally be used to preheat the carrier gas. The combination of the gas distribution manifold or plenum **628,** heating elements **602, 630,** gas inlet tube **626,** electrical wires **648, 650** and contacts **644, 646,** along with the open cell heating elements **602, 630** is referred to herein as a vapor deposition head **652.**

In this embodiment, there is a temperature gradient established through the thickness of the foam structures **602, 630** in the vapor flow direction such that the temperature is highest where the replenishment vapor enters the foam structure **630** and the temperature is lowest on the surface of the foam structure **602** opposite the target substrate **654** supported on substrate holder **656** within deposition chamber **658.** Substrate holder **656** controls the temperature of substrate **654** and the interior of deposition chamber **658** is maintained at a desired pressure by vacuum pump **662** in combination with pressure sensor **664** and pressure controller **666.** It is possible to achieve this thermal gradient by dimensioning the cross section of the foam elements **602, 630** through which an electrical current passes to establish a higher current density near the replenishment vapor inlet. It is also possible to use two or more individually controllable foam elements **602, 630** to achieve the required thermal gradient. Naturally, some thermal gradient through the thickness of the foam elements **602, 630** is achieved due to the presence of the heated replenishment vapor manifold on one side and the presence of a much cooler substrate 637 on the other side. As the replenishment vapor molecules enter the open cell foam structure along with carrier gas molecules having a mean free path about equal to the cell dimensions, they collide frequently with each other and with the ligaments of the foam structure. The vapor molecules colliding with the ligaments in progressing through the thickness of the foam have a probability of condensing with each collision and have an increasing probability of condensing on the increasingly cooler ligaments. With a single foam element having a one centimeter thickness, the vapor specific sieve behavior discussed previously was observed but generating a steady re-evaporated vapor flux completely independent from a concurrent replenishment vapor flux was not achieved. By adding a second, 1 cm thick foam element or by using a thicker foam element, the probability of condensing collisions is increased and the temperature differential in the flow direction can be increased such that virtually all of the replenishment vapor molecules are forced to condense before travelling through the entire foam thickness. Complete isolation between instabilities in the replenishment vapor flux and the output vapor flux can be achieved because the replenishment vapor first condenses, if only momentarily, before being re-evaporated at a highly stable and controllable rate. The momentary condensation regime is most desirable where extremely thermally sensitive materials are used. The momentary condensation regime is also most desirable where the replenishment vapor consists of more than one material and especially when the saturation vapor pressures of the more than one material are dissimilar. In this manner, the infinitesimal enveloping organic material coating of the foam structure is renewed or maintained by a continuous or intermittent flux of replenishment organic material vapor distributed uniformly over the surface of the open cell foam structure. This replenishment vapor substantially condenses in the form of a conformal, thin condensate coating on the foam ligaments directly. This embodiment allows continuous deposition onto a moving substrate such as in roll to roll production as long as the average replenishment vapor flux is equal to the average deposition flux. With this embodiment, a widely fluctuating input vapor rate supplied to the open cell foam structure such as by flash vaporization or through a typical vaporization in a crucible, can be transformed into a vapor output rate from the open cell foam structure to the target substrate with less than 1 percent variation.

Looking at Figure **15A****,** there is shown a cross section view of vapor deposition apparatus **600.** Heater **630** is sandwiched between electrodes **668, 670.** The electrodes **668, 670** are made of a conductive metal foil, and electrical current flows through the electrodes **668, 670** to the ligaments of heater **630** through electrodes **668, 670** to cause resistance heat to be produced in the ligaments. Electrical cable leads or wires **648, 650** connect to electrodes **668, 670,** respectively. Electrodes **668, 670** preferably take the form of conductive foils. A variety of metals can be used for the electrodes **668, 670.** Conveniently, titanium, tantalum, tungsten, or molybdenum or coatings of these materials on softer metals such as copper or silver can be used due to their relative chemical inertness at elevated temperatures. Compliant elements **672, 674** are heat resistant and, optionally, thermally conductive material. Compliant elements **672, 674** can conform to the surface texture of heater **630** and create local deformation of electrodes **668, 670** when the heater **630** is pressed against the compliantly supported electrodes **668, 670.** One example of useful compliant material is GRAFOIL®. UCAR Carbon Company Inc. of Wilmington, DE., manufactures GRAFOIL® Flexible Graphite as a rolled sheet product that exhibits good heat resistance and typically exceeds 97% elemental carbon by weight.

The sandwich configuration shown in Figure **15A** provides low contact resistance between the heater **600** and the electrodes **668, 670,** insuring that at least 90 percent of the heat is generated in the ligaments of heater **630** instead of at the interface between the electrodes **668, 670** and the heater **630.** Nano-particulate silver paint can also be used to lower the electrical contact resistance between the electrodes **668, 670** and the carbon foam material of the heater **630.** Because the silver particles are of a nanometer size, they soften and melt at temperatures hundreds of degrees less that the melting temperature of bulk silver. This behavior is very size dependent and facilitates the establishment of excellent electrical contact between the electrodes **668, 670** and the carbon foam material of the heater **630.** The heater **630,** electrodes **668, 670** and compliant elements **672, 674** are clamped together by contacts **644, 646.** Contacts **644, 646** may be electrically conductive and be attached to electrodes **668, 670,** respectively to carry current to the heater **630.** Alternately, the contacts **644, 646** could be electrical insulators or have an electrically insulating coating but act as thermal conductors to cool heater **630.** Isolating element **676** electrically and thermally isolates the heating structure from the plenum **628** and the entire assembly is unitized by clamping structure **678.** A thermocouple **680** or infrared sensor can be used to measure the temperature of heater **630** and provide feedback to control the current delivered to heater **630.** It is also possible to measure the voltage and current delivered to heater **630** as a function of temperature to determine the effective electrical resistance. Most materials have a measurable temperature coefficient of resistance and after calibration; it is possible to infer the average heater temperature based on the effective resistance.

A sensor **682** can be used in-situ to measure the vapor flux emanating from the foam structure **602** and this signal can be used to control the power delivered to foam element **602** or both foam elements **602** and **630** such that the output vapor flux can be controlled to very precise flux values that remain substantially invariant over long time intervals despite temperature and pressure variations in the system. Sensor **682** can be a quartz crystal oscillator or other in-situ deposited film thickness measurement sensor that measures the rate of deposition of the material vapor on the active face of the sensor. The feedback loop to the foam element **602** and or **630** can be of a very low bandwidth, measured in tens of seconds because of the inherently stable output flux from the foam element **602.** The action of the foam element can be compared to that of an electrical capacitor such that a relatively constant output signal is obtained even when the input signal is highly variable. This behavior is depicted graphically in Figure 16, which shows a widely variable input rate **684** of replenishment deposition vapor to an open cell foam heating element **10** to form a vapor deposition coating thereon. Yet the output rate **686** of deposition vapor generated by heating the foam heating element **10** is very stable. The control system could advantageously also contain a cascaded control loop to adjust the average replenishment vapor flux of vapor sources **604** and **606** based on a persistent positive or negative control signal in the primary loop controlling the power delivered to the foam element **602.**

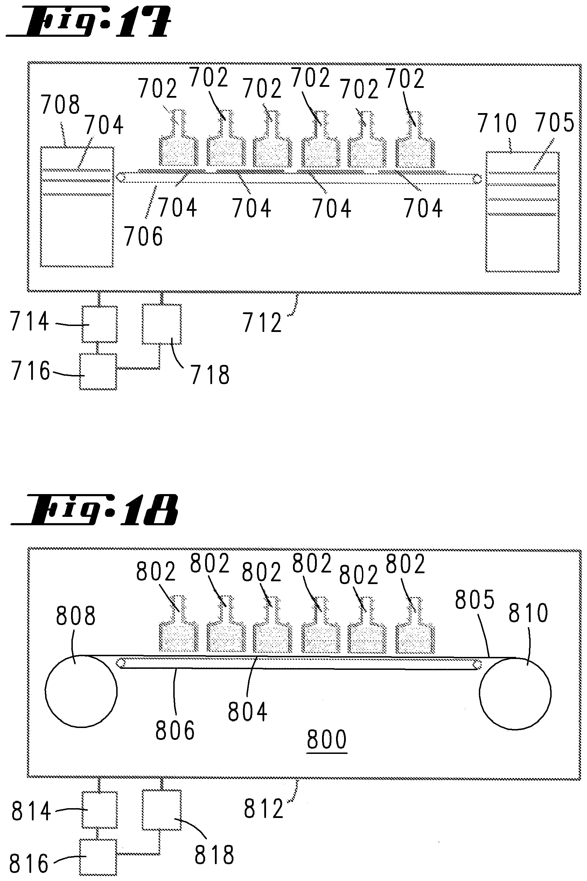

We have described the use of the open cell foam structures in fairly general terms but the illustrations show the foam elements being used in what may be analogized to showerhead-type arrangement, with individual foam elements having a generally square shape. It is also possible to use the foam in the form of a long rectangle such as would be applicable for a linear manifold used with in-line and roll-to-roll deposition. Figure 17 depicts an in-line deposition system **700** where multiple vapor deposition heads **702** are arranged in series. Each vapor deposition head **702** is substantially identical to the vapor deposition head **140** shown in Figure 5, or alternatively, the vapor deposition heads shown in Figure 15. A plurality of substrates **704** supported on a conveyor system **706** are transported in proximity to vapor deposition heads **702** and receive a coating of the respective deposition materials emanating from each vapor deposition heads **702** to produce a layered coating on substrates **704.** The substrates **704** are shown as being delivered from a substrate supply magazine **708,** transported on a substrate conveyor system **706** in close proximity to vapor deposition heads **702** and delivered to a receiving substrate magazine **710.** One skilled in the art will appreciate that the substrates **704** may be delivered to conveyor system **706** by means other than magazine **708,** transported by means other than conveyor system **706,** and the coated substrates **705** may be received by means other than magazine **710.** The vapor deposition heads **702,** conveyor system **706,** substrate supply magazine **708,** and receiving substrate magazine **710** are contained within a vacuum chamber **712.** The pressure in the vacuum chamber **712** is controlled through a feedback system comprising a pressure sensor **714,** a pressure controller **716** and a vacuum pump **718.**

Figure 18 depicts an in-line deposition system **800** where multiple vapor deposition heads **802** are arranged in series. Each vapor deposition head **802** is substantially identical to the vapor deposition head **140** shown in Figure 5, or alternatively, the vapor deposition heads shown in Figure 15. An extended length substrate **804** supported on a conveyor system **806** is transported in proximity to vapor deposition heads **802** and receives a coating of the respective deposition materials emanating from each of the vapor deposition heads **802** to produce a layered coating on substrate **804.** The substrate **804** is shown as being delivered from a roll **808,** transported on a substrate conveyor system **806** in close proximity to vapor deposition heads **802** and delivered to a receiving roll **810.** One skilled in the art will appreciate that the substrate **804** may be delivered to conveyor system **806** by means other than roll **808,** transported by means other than conveyor system **806,** and the coated substrate **805** may be received by means other than roll **810.** The vapor deposition heads **802,** conveyor system **806,** substrate supply roll **808,** and substrate receiving roll **810** are contained within a vacuum chamber **812.** The pressure in the vacuum chamber **812** is controlled through a feedback system comprising a pressure sensor **814,** a pressure controller **816** and a vacuum pump **818.**

The term "extended length substrate" as used herein is intended include a substrates having a length that is greater than the length of the deposition chamber. This necessarily includes the roll-to-roll configuration shown in Figure 18.

The roll-to-roll configuration depicted in Figure 18 demonstrates that the present invention is applicable to batch and continuous deposition processes on both discrete and extended substrates. The flexible substrate can be made from glass, aluminum or stainless steel foil. These foils are typically between 25 and 100 microns thick. Polymeric substrates such as PET and PEN can also be used after a moisture barrier film coating has been first deposited as a support layer for the OLED material.

In each of these embodiments, the deposition rate stability on the target substrate is determined by the vapor generation rate stability of the open cell foam structure and is decoupled from any variability in the replenishment vapor flux due to difficulties and variability in metering and vaporizing minute powder quantities on an as-needed basis. By utilizing a phase change from gas to solid between the input vapor and the output vapor in the open cell foam, the objective of establishing and maintaining a controllable, precise and invariant flux of the output vapor is decoupled from the difficulties of maintaining a stable deposition rate from a vapor on demand flash vaporization system.

The invention allows substantial simplification in the preparation and vaporization of organic material for making OLED devices through consideration of the organic material purification process and consideration of the variables such as temperature, thermal exposure time, thermal conductivity, surface area, partial pressure, total pressure and convection that control organic material vaporization and decomposition.

In the practice of the present invention the thickness of the solid coating of material vapor deposited onto the surface of the three-dimensional open cell reticulated structure is preferably less than 5µm. The preferred thickness will vary, however, by the material being deposited. The more thermally robust materials will support longer thermal exposure times and can therefore be coated to a greater thickness to enable longer deposition autonomy. The least thermally robust materials will likely only support sub-micron thicknesses to insure that they are consumed before they decompose. These sensitive materials are good candidates for use with the continuous vapor replenishment mode of operation.

In the practice of the present invention the solid coating of material vapor deposited onto the surface of the three-dimensional open cell reticulated structure is substantially pure. The term "substantially pure" is used herein to denote of at least 99.5% purity and less than 10 PPM of halogens such as fluorine, chlorine, bromine. This is a significant improvement over the typical solution purification of OLED materials, which may vary by material and synthesis method used. However, it is believed that solution purification of OLED materials is generally limited to less than 97% or 98% purity. This may not seem like a large numerical difference but the performance and especially the lifetime of OLED devices can be degraded 10% by chlorine concentrations as low as 30 PPM.

OLED materials that can be vapor deposited with the present invention include, by way of example, TiOPC, NPB, LiQ, TcTa, Bphen, DMQA, DBQA, Rubrene, TMDBQA, Ir(ppy)3, Ir(ppy)2(acac), Ir(mppy)3, CBP, AlQ3, DCJTB, Ir(piq)3, Ir(piq)2(acac), Ir(2-phq)3, Ir(2-phq)2(acac), Ir(BT)2(acac), DCM, F4-TCNQ, Perylene, Pentacene.

While the present invention has been discussed primarily as a method for vapor depositing OLED materials, it is possible to vapor deposit metals and ceramics. Glassy carbon is an example of a non-graphitizing carbon that is a carbon which cannot be transformed into crystalline graphite even at temperatures of 3000°C and above (Franklin, Proc. Roy. Soc., A, 209, 196, 1951, Harris, Int. Mater. Rev., 42, 206. 1997). In addition to very high thermal stability, its distinguishing properties include its extreme resistance to chemical attack: it has been demonstrated that the rates of oxidation of glassy carbon in oxygen, carbon dioxide or water vapour are lower than those of any other carbon (Jenkins and Kawamura, Polymeric Carbons - Carbon Fibre, Glass and Char (Cambridge: Cambridge University Press). 1976). It is also highly resistant to attack by acids. Thus, while normal graphite is reduced to a powder by a mixture of concentrated sulphuric and nitric acids at room temperature, glassy carbon is unaffected by such treatment, even after several months.

The inertness of glassy carbon makes it a useful crucible material for melting and vaporizing a wide range of organic and inorganic materials including metals. The process described here for controllably vaporizing organic materials can therefore be used to controllably vaporize a wide range of materials whose vaporization temperatures are below 3000°C. This capability encompasses most of the elements from the periodic table including elements from groups I, III and VI that are notable for photovoltaic applications. Copper, indium, gallium and selenium could be vaporized to deposit CIGS, cadmium telluride could also be vapour deposited by this method to achieve a uniform film coating on a continuously moving substrate for use in high volume fabrication of photovoltaic devices.

While the intermediate vapor deposition receptacle is described herein as a conductive three-dimensional, open cell, reticulated structure, preferably an open cell vitreous carbon foam, it should be understood that the intermediate vapor deposition receptacle can be formed differently. As an example, it may be comprised of multiple layers of carbon fiber mesh or lattice overlaid on one another to yield a conductive, open, three-dimensional reticulated structure with a multitude of tortuous flow paths therethrough. The tortuous flow paths promote mixing of the gas with the organic vapor generated around the heated ligaments or fibers, and the flow and temperature of the inert carrier gas contribute to controlling the rate of generation and transport of the organic vapor toward the deposition target substrate.

### PARTS LIST

- **10**: open cell foam structures
- **11**: sublimation purification apparatus
- **12**: material to be purified
- **14**: vaporization apparatus
- **16**: vacuum chamber
- **18**: heating elements
- **20**: crucible
- **21**: vacuum pump
- **22**: condensate collection tube
- **24**: pressure sensor
- **26**: pressure controller
- 28: struts or ligaments
- 30: coating of condensed material
- 32: vapor deposition apparatus
- 34: input tube
- 36: mass flow controller
- 38: gas heater
- 40: input duct
- **42**: gas distribution manifold or plenum
- **44, 45**: wires
- **46, 48**: contacts
- **50**: vacuum chamber
- **52**: substrate holder
- **54**: substrate
- **56**: vacuum pump
- **58**: pressure sensor
- **60**: pressure controller
- **62**: heating elements
- **64, 66**: electrodes
- **68, 70**: cable leads
- **72, 74**: compliant elements
- **76, 78**: contacts
- **80**: isolating element
- **84**: clamping structure
- **86**: thermocouple
- **100**: vapor deposition apparatus
- **102**: input tube
- **104**: mass flow controller
- **106**: gas heater
- **108**: input duct
- **110**: gas distribution manifold or plenum
- **112, 113**: wires
- **114, 116**: contacts
- **118**: vacuum chamber
- **120**: substrate holder
- **122**: substrate
- **124**: vacuum pump
- **126**: pressure sensor
- **128**: pressure controller
- **130**: heating elements
- **131, 133**: compliant elements
- **132**: second open cell foam structure or heating element
- **134, 136**: contacts
- **135, 137**: electrodes
- **138, 139**: wires
- **140**: vapor deposition head
- **142, 144**: electrodes
- **146, 148**: compliant elements
- **150**: isolating element
- **152**: clamping structure
- **154**: heater
- **300**: deposition source supply head
- **302**: rotor
- **304**: stator
- **306**: frame
- **307**: support faces
- **308**: feed tube
- **309**: contact
- **310**: duct
- **312**: duct
- **314**: substrate
- **316**: substrate holder
- **320**: multi-faceted prism
- **322**: substrate holder
- **324**: target substrate
- **400**: deposition source supply head
- **402**: rotor
- **404, 406**: stator portions
- **408**: frames
- **410**: feed tube
- **412**: duct
- **414**: duct
- **416**: substrate
- **418**: substrate support
- **420**: duct
- **422**: duct
- **500**: vapor deposition head
- **502**: feed tube
- **504**: duct
- **506**: stator portion
- **508**: duct
- **510**: rotor
- **512**: substrate
- **514**: substrate holder
- **516**: feed tube
- **518**: duct
- **520**: stator portion
- **522**: duct
- **524**: substrate
- **600**: vapor deposition apparatus
- **602**: open cell foam element
- **604, 606**: vapor generator sources
- **608, 610**: carrier gas inlets
- **612, 614**: gas flow controllers
- **616**: vapor mixer
- **618**: dilution carrier gas inlet
- **620**: gas flow controller
- **622**: gas temperature controller
- **624**: conduit
- **626**: gas inlet tube
- **628**: gas distribution manifold or plenum
- **630**: open cell foam structure
- **631**: heating elements
- **632, 633**: wires
- **634, 635**: contacts
- **636**: substrate holder
- **637**: substrate
- **638**: vacuum chamber
- **639**: vacuum pump
- **640**: pressure sensor
- **642**: pressure controller
- **644, 646**: contacts
- **648, 650**: wires
- **652**: vapor deposition head
- **654**: target substrate
- **656**: substrate holder
- **658**: deposition chamber
- **660**: deposition chamber
- **662**: vacuum pump
- **664**: pressure sensor
- **666**: pressure controller
- **668, 670**: electrodes
- **672, 674**: compliant elements
- **676**: isolating element
- **678**: clamping structure
- **680**: thermocouple
- **682**: sensor
- **684**: variable input rate
- **686**: output rate
- **700**: in-line deposition system
- **702**: vapor deposition heads
- **704**: substrates
- **705**: coated substrates
- **706**: conveyor system
- **708**: substrate supply magazine
- **710**: receiving substrate magazine
- **712**: vacuum chamber
- **714**: pressure sensor
- **716**: pressure controller
- **718**: vacuum pump
- **800**: in-line deposition system
- **802**: vapor deposition heads
- **804**: substrate
- **805**: coated substrate
- **806**: conveyor system
- **808**: substrate supply roll
- **810**: substrate receiving roll
- **812**: vacuum chamber
- **814**: pressure sensor
- **816**: pressure controller
- **818**: vacuum pump

## Claims

1. A vapor deposition system for delivering a mixture of a carrier gas and a deposition gas to a temperature controlled target substrate comprising:
(a) a first member;
(b) a second member positioned adjacent the first member for relative movement between the second member and the first member, the first member including a plurality of support faces, each of the support faces having a frame mounted thereto;
(c) a three-dimensional, open cell, reticulated structure heater element having a solid coating of a selected vapor deposition material deposited thereon supported within each frame, the heater element capable of controllably vaporizing the solid coating;
(d) a carrier gas feed tube connected to the second member for delivering carrier gas to a delivery duct within the second member;
(e) a plurality of facet ducts in the first member, each facet duct aligning with a respective support face, the relative movement of the first member and second member allowing the delivery duct to be aligned with any selected one of the facet ducts, the carrier gas thereby flowing through the heater element adjacent the selected facet duct.

2. A vapor deposition system according to claim 1, wherein the first member is a rotor and the second member is a stator
wherein the stator is rotatably positioned within the rotor or
about the stator and in particular
wherein:
through the relative rotation between the stator and the rotor, each heater may be positioned to face the target substrate.

3. A vapor deposition system acccording to claim 1 or 2 wherein:
each frame supports a heater having a solid coating of a different selected vapor deposition material vapor deposited thereon so that different coating materials may be sequentially coated onto the target substrate.

4. A vapor deposition system acccording to claim 1 to 3 further comprising:
a rotatable target substrate support structure for supporting a plurality of target substrates wherein each of the target substrates so supported are individually and sequentially positioned through rotation of the support structure to reside facing the selected one of the facet ducts.

5. A vapor deposition system acccording to claim 1 to 4 wherein:
the stator includes first and second stator portions,
wherein a deposition gas feed tube is connected to a second stator portion for delivering carrier gas and deposition gas to a recharging duct within the second stator portion, and
wherein the rotor is rotatably positioned about the first and second stator portions and rotation of the rotor further allowing the recharging duct to be aligned with any selected one of the facet ducts so that vapor deposition material may be delivered through the deposition gas feed tube to be vapor deposited on a spent heater element.

6. A rechargeable vapor deposition source supply head for delivering a mixture of a carrier gas and a deposition gas to a temperature controlled target substrate comprising:
(a) a first member having a plurality of heater ducts therethrough and having a plurality of heater elements supported therefrom in substantial planar alignment with each other, each heater element aligning with a respective heater duct, each heater element being an electrically conductive, three-dimensional, open cell, reticulated structure having a solid coating of a selected vapor deposition material vapor deposited thereon, the heater element capable of controllably vaporizing the solid coating;
(b) a second member attached to the first member such that the first member moves relative to the second member, the second member including a carrier gas feed duct and a deposition gas feed duct, the first member being moveable to align a selected heater element with either the carrier gas feed duct or the deposition gas feed duct;
(c) a carrier gas feed tube connected to the second member for delivering carrier gas to carrier gas feed duct; and
(d) a deposition gas feed tube connected to the second member for delivering deposition gas to the deposition gas feed duct.

7. A vapor deposition apparatus comprising:
(a) at least one vapor generator source for supplying a replenishment deposition gas to a plenum;
(b) at least one carrier gas supply line for supplying a carrier gas through the at least one vapor generator source to the plenum such that the replenishment deposition gas and the carrier gas form a first mixture that is delivered to the plenum;
(c) a three-dimensional, open cell, reticulated structure having a solid coating of a vapor deposition material thereon, the three-dimensional, open cell, reticulated structure residing within the plenum, the three-dimensional, open cell, reticulated structure having a temperature gradient therethrough in the direction of flow such that the replenishment deposition gas condenses on the three-dimensional, open cell, reticulated structure;
(d) means for vaporizing the solid coating to form a deposition gas that mixes with the carrier gas to form a second mixture;
(e) means for delivering the second mixture at a stable flow rate to a temperature controlled substrate within a chamber; and
(f) an exhaust port through which the carrier gas is withdrawn from the chamber.

8. A vapor deposition apparatus comprising:
(a) a plurality of vapor deposition heads positioned within a deposition chamber, each deposition head including a three-dimensional, open cell, reticulated structure having a solid coating of a vapor deposition material thereon; and
(b) a conveyor system residing within the deposition chamber for transporting at least one target substrate through the deposition chamber in close proximity to the plurality of deposition heads with each of the plurality of vapor deposition heads depositing a separate layer of vapor deposition material on the at least one target substrate.

9. A vapor deposition apparatus according to claim 6 to 8 wherein:
each of the conductive, three-dimensional, open cell, reticulated structures is a heater element,
wherein the three-dimensional, open cell, reticulated structure is electrically conductive and
in particular wherein the apparatus comprising a power supply for supplying an electrical current to the heater elements.

10. A vapor deposition apparatus according to claim 9 further comprising:
(a) a respective pair of electrodes electrically connected to each of the heater elements;
(b) a respective conduit through which an inert carrier gas is delivered to flow through each of the heater elements to yield a controllable partial pressure of the deposition gas within each heater element as each of the plurality of heater elements vaporizes the solid coating thereon, each vaporized solid coating and the carrier gas forming a respective mixture;
(c) a vacuum chamber in which a temperature controlled substrate is supported; and
(d) means for delivering the respective mixtures to the deposition chamber.

11. A vapor deposition apparatus according to claim 8 to 10 wherein:
each of the separate layers is formed with a different vapor deposition material.

12. A vapor deposition apparatus according to claim 11 wherein:
the solid coating is a solid organic, in particular an OLED material, organo-metallic material and/or
wherein
the solid coating is a solid metal or ceramic material.

13. A vapor deposition apparatus according to claim 6 to 12 wherein:
the conductive, three-dimensional, open cell, reticulated structure is a vitreous carbon foam.

14. A vapor deposition apparatus according to claim 6 to 13 further comprising:
a uniform coating of a refractory metal or a ceramic on the first conductive, three-dimensional, open cell, reticulated structure,
wherein
the refractory metal imay be tungsten, tantalum or molybdenum.

15. A vapor deposition apparatus apparatus according to claim 6 to 14 further comprising:
a vapor deposition rate sensor for measuring the material deposition rate and providing feedback to control the electrical current delivered to the heater element and to control the replenishment deposition vapor flux.

## Patentansprüche

1. Gasabscheidesystem zum Bereitstellen einer Mischung aus einem Trägergas und einem Beschichtungsgas für ein temperiertes Zielsubstrat, aufweisend:
(a) ein erstes Glied;
(b) ein zweites Glied, das beweglich gegenüber dem ersten Glied an das erste Glied angrenzt, wobei das erste Glied eine Vielzahl von Stützflanken aufweist, wobei jede Stützflanke einen an ihr befestigten Rahmen aufweist;
(c) ein dreidimensional, offenzellig, netzartige strukturiertes Heizelement, auf dem eine feste Beschichtung eines ausgewählten Gasphasenbeschichtungsmaterials abgeschieden ist und welches von jeweils einem Rahmen getragen ist, wobei das Heizelement in der Lage ist, die feste Beschichtung kontrolliert zu verdampfen;
(d) ein Trägergasspeiserohr, welches mit dem zweiten Glied zur Bereitstellung eines Trägergases zu einer Zuleitung im zweiten Glied verbunden ist;
(e) eine Vielzahl von Facettenkanälen im ersten Glied, wobei jeder Facettenkanal auf eine Stützflanke ausgerichtet ist, wobei die relative Bewegung des ersten Gliedes gegenüber dem zweiten Glied die Zuleitung zu einem ausgewählten Facettenkanal ausrichtet, so dass das Trägergas durch das an den Facettenkanal angrenzende Heizelement fließt.

2. Ein Gasabscheidesystem nach Anspruch 1, wobei das erste Glied ein Rotor und das zweite Glied ein Stator ist,
wobei der Stator drehbar im Rotor oder um den Rotor angeordnet ist und insbesondere wobei eine relative Drehung des Stators gegenüber dem Rotor jedes Heizelement in eine dem Zielsubstrat zugewandte Stellung bringbar ist.

3. Gasabscheidesystem nach Anspruch 1 oder 2, wobei jeder Rahmen ein Heizelement trägt, das eine feste Beschichtung eines anderen ausgewählten Gasphasenbeschichtungsmaterials aufweist, so dass verschiedene Beschichtungsmaterialien fortlaufend auf dem Zielsubstrat abgeschieden werden können.

4. Gasabscheidesystem nach Anspruch 1 bis 3, weiter aufweisend:
eine drehbare Zielsubstrattragstruktur zum Tragen einer Vielzahl von Zielsubstraten, wobei jedes der derart getragenen Zielsubstrate individuell und fortlaufend durch Rotation der Tragstruktur derart positionierbar sind, dass es einen ausgewählten Facettenkanal gegenüberliegt.

5. Gasabscheidesystem nach Anspruch 1 bis 4, wobei der Stator einen ersten und einen zweiten Statorabschnitt aufweist, wobei ein Beschichtungsgasspeiserohr mit dem zweiten Statorabschnitt verbunden ist, um ein Trägergas und ein Beschichtungsgas in einen Anreicherungskanal im zweiten Statorabschnitt einzuspeisen, wobei der Rotor drehbar um den ersten und zweiten Statorabschnitt angeordnet ist, und die Rotation des Rotors es ermöglicht, dass der Anreicherungskanal zu einer der ausgewählten Stützflanken ausgerichtet wird, so dass Gasphasenbeschichtungsmaterial durch das Beschichtungsgasspeiserohr geleitet wird, um auf einem verbrauchten Heizelement abgeschieden zu werden.

6. Versorgungskopf einer wiederaufladbaren Gasabscheidequelle zum Bereitstellen einer Mischung aus einem Trägergas und einem Beschichtungsgas für ein temperiertes Zielsubstrat aufweisend:
(a) ein erstes Glied mit einer Vielzahl von Heizkanälen und einer Vielzahl von Heizelementen, die von ihm in einer im Wesentlichen planaren Anordnung getragen werden, wobei jedes Heizelement zu einem Heizkanal ausgerichtet ist, wobei jedes Heizelement eine elektrisch leitfähige, dreidimensionale, offenzellige, netzartige Struktur aufweist, die eine feste Beschichtung eines ausgewählten Gasphasenbeschichtungsmaterials enthält, die darauf abgeschieden ist, wobei das Heizelement in der Lage ist, kontrollierbar die feste Beschichtung zu verdampfen;
(b) ein zweites Glied, welches derart am ersten Glied befestigt ist, dass das erste Glied relativ gegenüber dem zweiten Glied bewegt werden kann, wobei das zweite Glied einen Trägergaskanal und einen Beschichtungsgaskanal aufweist, wobei das erste Glied derart beweglich ist, dass ein ausgewähltes Heizelement entweder zu einem Trägergaskanal oder einem Beschichtungsgaskanal ausgerichtet werden kann;
(c) ein Trägergasrohr, das derart mit dem zweiten Glied verbunden ist, dass ein Trägergas in den Trägergaskanal einspeisbar ist; und
(d) ein Beschichtungsgasspeiserohr, welches mit dem zweiten Glied derart verbunden ist, dass ein Beschichtungsgas in den Beschichtungsgaskanal einspeisbar ist.

7. Gasabscheidevorrichtung aufweisend:
(a) zumindest eine Gaserzeugungsquelle zur Versorgung eines Plenums mit einem Anreicherungsbeschichtungsgas;
(b) zumindest eine Trägergasleitung zum Bereitstellen eines Trägergases durch die mindestens eine Gaserzeugungsquelle zum Plenum derart, dass das Anreicherungsbeschichtungsgas und das Trägergas eine erste Mischung bilden, die zum Plenum geliefert wird;
(c) eine dreidimensionale, offenzellige, netzartige Struktur, die eine feste Beschichtung eines Gasphasenbeschichtungsmaterials aufweist, wobei die dreidimensionale, offenzellige, netzartige Struktur im Plenum angeordnet ist und die dreidimensionale, offenzellige, netzartige Struktur einen Temperaturgradienten in Richtung des Flusses aufweist, so dass das Anreicherungsbeschichtungsgas auf der dreidimensionalen, offenzelligen, netzartigen Struktur kondensiert;
(d) Mittel zur Verdampfung der festen Beschichtung, um ein Beschichtungsgas zu erzeugen, das sich mit dem Trägergas zur Bildung einer zweiten Mischung mischt;
(e) Mittel zur Bereitstellung der zweiten Mischung bei einer stabilen Flussrate zu einem temperierten Substrat innerhalb einer Kammer; und
(f) eine Abgasöffnung, durch welche das Trägergas aus der Kammer herausgeleitet wird.

8. Eine Gasabscheidevorrichtung aufweisend:
(a) eine Vielzahl von Gasabscheideköpfen, die in einer Abscheidekammer angeordnet sind, wobei jeder Gasabscheidekopf eine dreidimensionale, offenzellige, netzartige Struktur aufweist, die eine feste Beschichtung eines festen Abscheidematerials darauf aufweist;
(b) ein Fördersystem, welches in der Abscheidekammer angeordnet ist, um zumindest ein Zielsubstrat durch die Abscheidekammer mit einem kleinen Abstand zu der Vielzahl von Gasabscheideköpfen zu fördern, wobei jeder der Vielzahl der Gasabscheideköpfe eine gesonderte Schicht eines Gasbeschichtungsmaterials auf das zumindest eine Zielsubstrat abscheidet.

9. Eine Gasphasenabscheidevorrichtung nach Anspruch 6 bis 8, wobei jede der leitenden, dreidimensionalen, offenzelligen, netzartigen Struktur ein Heizelement ist,
wobei die dreidimensionale, offenzellige, netzartige Struktur elektrisch leitend ist und
insbesondere wobei die Vorrichtung eine Leistungsversorgung aufweist, um die Heizelemente mit elektrischem Strom zu versorgen.

10. Gasabscheidevorrichtung nach Anspruch 9 weiter aufweisend:
(a) ein zugeordnetes Paar von Elektroden, die elektrisch leitend mit jedem Heizelement verbunden sind;
(b) eine jeweilige Leitung, durch welche ein inertes Trägergas bereitgestellt wird, um durch jedes der Heizelemente zu fließen, um durch Verdampfen der festen Beschichtung eines jeden Heizelementes der Vielzahl der Heizelemente einen kontrollierbaren Dampfdruck eines Beschichtungsgases zu erzeugen und die Bildung einer Gasmischung mit dem Trägergas;
(c) eine Vakuumkammer, in welcher ein temperiertes Substrat getragen ist; und
(d) Mittel zum Einspeisen der Gasmischung in die Kammer.

11. Eine Gasabscheidevorrichtung nach Anspruch 8 bis 10 wobei jede einer Vielzahl separater Schichten von einem anderen Beschichtungsmaterial gebildet ist.

12. Eine Gasabscheidevorrichtung nach Anspruch 11, wobei die feste Beschichtung ein organisches Material und insbesondere ein OLED-Material, ein metallorganisches Material ist und/oder wobei die feste Beschichtung aus einem festen Material oder einem keramischen Material besteht.

13. Eine Gasabscheidevorrichtung nach Anspruch 6 bis 12, wobei die leitende, dreidimensionale, offenzellige, netzartige Struktur ein glasartiger Kohlenstoffschaum ist.

14. Eine Gasabscheidevorrichtung nach Anspruch 6 bis 13, ferner aufweisend:
eine gleichmäßige Beschichtung eines hitzebeständigen Metalls oder einer Keramik auf einer ersten leitenden, dreidimensionalen, offenzelligen, netzartigen Struktur, wobei das hitzebeständige Metall Wolfram, Tantal oder Molybdän sein kann.

15. Eine Gasabscheidevorrichtung nach Anspruch 6 bis 14, ferner aufweisend;
einen Abscheideratensensor, um die Materialabscheiderate zu messen und um eine Antwort zu erzeugen, um den elektrischen Strom zum Heizelement zu steuern und um den Anreicherungsbeschichtungsgasfluss zu steuern.

## Revendications

1. Système de dépôt en phase vapeur pour la distribution d'un mélange d'un gaz support et d'un gaz de dépôt sur un substrat cible régulé en température, comprenant :
(a) un premier élément ;
(b) un second élément positionné de manière adjacente au premier élément pour un mouvement relatif entre le premier élément et le second élément, le premier élément comprenant une pluralité de faces support, chacune des faces support ayant un cadre monté sur celle-ci;
(c) un élément de chauffage à structure réticulée, à cellules ouvertes, tridimensionnelle, sur lequel a été déposé un revêtement solide d'un matériau de dépôt en phase vapeur sélectionné supporté à l'intérieur de chaque cadre, l'élément de chauffage étant capable de vaporiser de manière régulée le revêtement solide;
(d) un tuyau d'alimentation en gaz support raccordé au second élément pour la distribution du gaz support à une conduite de distribution à l'intérieur du second élément;
(e) une pluralité de conduites de facette dans le premier élément, chaque conduite de facette s'alignant avec une face support respective, le mouvement relatif du premier élément et du second élément permettant à la conduite de distribution de s'aligner avec l'une quelconque des conduites de facette sélectionnée, le gaz support s'écoulant de la sorte à travers l'élément de chauffage de manière adjacente à la conduite de facette sélectionnée.

2. Système de dépôt en phase vapeur selon la revendication 1 dans lequel le premier élément est un rotor et le second élément est un stator
dans lequel le stator est positionné à rotation dans le rotor ou
autour du stator et en particulier
dans lequel :
par la rotation relative entre le stator et le rotor, chaque élément de chauffage peut être positionné face au substrat cible.

3. Système de dépôt en phase vapeur selon la revendication 1 ou 2, dans lequel : chaque cadre porte un élément de chauffage sur lequel a été déposé en phase vapeur un revêtement solide d'un matériau de dépôt en phase vapeur sélectionné différent de manière à pouvoir revêtir séquentiellement le substrat cible de différents matériaux de revêtement.

4. Système de dépôt en phase vapeur selon la revendication 1 à 3, comprenant en outre :
une structure rotative de support de substrat cible destinée à porter une pluralité de substrats cibles dans lequel chacun des substrats cibles ainsi portés est individuellement et séquentiellement positionné par rotation de la structure de support pour se trouver face à la conduite de facette sélectionnée.

5. Système de dépôt en phase vapeur selon la revendication 1 à 4, dans lequel :
le stator comprend des première et seconde parties de stator,
dans lequel un tube d'alimentation en gaz de dépôt est connecté à une seconde partie de stator pour distribuer un gaz support et un gaz de dépôt à une conduite de recharge à l'intérieur de la seconde partie de stator, et
dans lequel le rotor est positionné à rotation autour des première et seconde parties de stator et la rotation du rotor permet en outre à la conduite de recharge d'être alignée avec l'une quelconque des conduites de facette sélectionnée de manière que le matériau de dépôt en phase vapeur puisse être distribué à travers le tuyau d'alimentation en gaz de dépôt pour être déposé en phase vapeur sur un élément de chauffage usé.

6. Tête d'alimentation source de dépôt en phase vapeur rechargeable pour la distribution d'un mélange d'un gaz support et d'un gaz de dépôt sur un substrat cible régulé en température, comprenant :
(a) un premier élément ayant une pluralité de conduites de chauffage le traversant et ayant une pluralité d'éléments de chauffage le supportant selon un alignement sensiblement plan les uns par rapport aux autres, chaque élément de chauffage s'alignant avec une conduite de chauffage respective, chaque élément de chauffage étant une structure réticulée, à cellules ouvertes, tridimensionnelle, électriquement conductrice, sur laquelle a été déposé en phase vapeur un revêtement solide d'un matériau de dépôt en phase vapeur sélectionné, l'élément de chauffage étant capable de vaporiser de manière régulée le revêtement solide;
(b) un second élément fixé au premier élément de sorte que le premier élément se déplace par rapport au second élément, le second élément comprenant une conduite d'alimentation en gaz support et une conduite d'alimentation en gaz de dépôt, le premier élément étant déplaçable pour aligner un élément de chauffage sélectionné, soit avec la conduite d'alimentation en gaz support, soit avec la conduite d'alimentation en gaz de dépôt ;
(c) un tuyau d'alimentation en gaz support connecté au second élément pour la distribution du gaz support à la conduite d'alimentation en gaz support ;
(d) un tuyau d'alimentation en gaz de dépôt connecté au second élément pour la distribution du gaz de dépôt à la conduite d'alimentation en gaz de dépôt.

7. Appareil de dépôt en phase vapeur, comprenant :
(a) au moins une source de production de vapeur pour fournir un apport en gaz de dépôt à un plénum ;
(b) au moins une ligne d'alimentation en gaz support pour fournir un gaz support à travers ladite au moins une source de production de vapeur au plénum de manière que l'apport en gaz de dépôt et le gaz support forment un premier mélange distribué au plénum ;
(c) une structure réticulée, à cellules ouvertes, tridimensionnelle, recouverte d'un revêtement solide d'un matériau de dépôt en phase vapeur, la structure réticulée, à cellules ouvertes, tridimensionnelle, étant logée à l'intérieur du plénum, la structure réticulée, à cellules ouvertes, tridimensionnelle, ayant un gradient de température dans la direction de l'écoulement tel que l'apport en gaz de dépôt se condense sur la structure réticulée, à cellules ouvertes, tridimensionnelle ;
(d) des moyens de vaporisation du revêtement solide pour former un gaz de dépôt qui se mélange avec le gaz support pour former un second mélange ;
(e) des moyens pour distribuer le second mélange à un débit stable à un substrat régulé en température à l'intérieur d'une enceinte ; et
(f) un port de sortie à travers lequel le gaz support est extrait de l'enceinte.

8. Appareil de dépôt en phase vapeur, comprenant :
(a) une pluralité de têtes de dépôt en phase vapeur positionnées à l'intérieur d'une enceinte de dépôt, chaque tête de dépôt comprenant une structure réticulée, à cellules ouvertes, tridimensionnelle, recouverte d'un revêtement solide d'un matériau de dépôt en phase vapeur ; et
(b) un système de transport logé à l'intérieur de l'enceinte de dépôt pour transporter au moins un substrat cible à travers l'enceinte de dépôt à proximité étroite de la pluralité de têtes de dépôt, chacune de la pluralité de têtes de dépôt déposant une couche distincte de matériau de dépôt en phase vapeur sur ledit au moins un substrat cible.

9. Appareil de dépôt en phase vapeur selon la revendication 6 à 8, dans lequel :
chacune des structures réticulées, à cellules ouvertes, tridimensionnelles, conductrices, est un élément de chauffage,
dans lequel la structure réticulée, à cellules ouvertes, tridimensionnelle, est électriquement conductrice et
en particulier dans lequel l'appareil comprend une alimentation pour fournir un courant électrique aux éléments de chauffage.

10. Appareil de dépôt en phase vapeur selon la revendication 9, comprenant en outre :
(a) une paire respective d'électrodes électriquement connectées à chacun des éléments de chauffage ;
(b) une conduite respective à travers laquelle un gaz support inerte est distribué pour s'écouler à travers chacun des éléments de chauffage pour produire une pression partielle réglable du gaz de dépôt à l'intérieur de chaque élément de chauffage pendant que chacun de la pluralité d'éléments de chauffage vaporise le revêtement solide qui le recouvre, chaque revêtement solide vaporisé et le gaz support formant un mélange respectif ;
(c) une enceinte sous vide dans laquelle est maintenu un substrat régulé en température ; et
(d) des moyens de distribution des mélanges respectifs à l'enceinte de dépôt.

11. Appareil de dépôt en phase vapeur selon la revendication 8 à 10 dans lequel : chacune des couches distinctes est formée avec un matériau de dépôt en phase vapeur différent.

12. Appareil de dépôt en phase vapeur selon la revendication 11, dans lequel :
le revêtement solide est un solide organique, en particulier un matériau OLED, un matériau organométallique et /ou
dans lequel
le revêtement solide est un solide métallique ou un matériau céramique.

13. Appareil de dépôt en phase vapeur selon la revendication 6 à 12, dans lequel :
la structure réticulée, à cellules ouvertes, tridimensionnelle, conductrice, est une mousse de carbone vitreux.

14. Appareil de dépôt en phase vapeur selon la revendication 6 à 13, comprenant en outre :
un revêtement uniforme d'une céramique ou d'un métal réfractaire sur la première structure réticulée ,à cellules ouvertes, tridimensionnelle, conductrice,
dans lequel
le métal réfractaire peut être du tungstène, du tantale ou du molybdène.

15. Appareil de dépôt en phase vapeur selon la revendication 6 à 14, comprenant en outre :
un capteur de vitesse de dépôt en phase vapeur pour mesurer la vitesse de dépôt du matériau et fournir un retour permettant de réguler le courant électrique fourni à l'élément de chauffage et de réguler le flux d'apport de vapeur de dépôt.
